# EUROPEAN PATENT SPECIFICATION

(11) **EP 3 970 963 B1**
(45) Date of publication and mention of the grant of the patent: **04.11.2026**
(21) Application number: 20805762.0
(22) Date of filing: 27.04.2020
(51) Int. Cl.: C09D 171/00, B05D 5/08, B05D 1/02, B05D 1/18, B05D 3/02, B05D 7/04, B05D 7/00, C08G 65/00, C08G 65/336

(54) **WATER REPELLENT AND OIL REPELLENT MEMBER, AND METHOD FOR PREPARING A WATER REPELLENT AND OIL REPELLENT MEMBER**
WASSERABSTOSSENDES UND ÖLABSTOSSENDES ELEMENT SOWIE VERFAHREN ZUR HERSTELLUNG EINES WASSERABWEISENDEN UND ÖLABWEISENDEN ELEMENTS
ÉLÉMENT HYDROFUGE ET OLÉOFUGE, ET PROCÉDÉ DE PRODUCTION D'UN ÉLÉMENT HYDROFUGE ET OLÉOFUGE

(30) Priority: 14.05.2019 JP 2019091198
(43) Date of publication of application: 23.03.2022
(73) Proprietor: Shin-Etsu Chemical Co., Ltd., Tokyo 100-0005 (JP)
(72) Inventor: YAMANE Yuji, Annaka-shi, Gunma 379-0224 (JP); SAKOH Ryusuke, Annaka-shi, Gunma 379-0224 (JP)
(74) Representative: Ter Meer und Partner mbB
(86) International application number: PCT/JP2020/018024
(87) International publication number: WO 2020/230618

(56) References cited:
- EP-A1- 3 643 495
- EP-A1- 3 693 160
- WO-A1-2012/157072
- WO-A1-2018/235778
- WO-A1-2018/235778
- WO-A1-2019/069642
- WO-A1-2019/069642
- WO-A1-2020/039795
- JP-A- 2007 119 643
- JP-A- 2016 071 338

## Description

### TECHNICAL FIELD

This invention relates to a water repellent and oil repellent member (water/oil repellent member) having excellent abrasion resistance and a method for preparing the same. More particularly, it relates to a water/oil repellent member comprising a functional film layer disposed on the surface of a substrate as a first layer, the functional film layer being composed mainly of silicon dioxide or including an uppermost layer of silicon dioxide, a layer formed as a second layer using an organosilicon compound having a plurality of silanol groups (silicon-bonded hydroxy groups) in the molecule, and a layer formed as a third layer using a fluorinated organosilicon compound, and a method for preparing the same.

### BACKGROUND ART

For the purpose of improving aesthetic appearance or visibility, the demand for the technology of rendering articles unsusceptible to staining or the technology of facilitating to clean off stains is increasing every year. In particular, since liquid crystal displays, organic EL displays, eyeglass lenses, smartphones, wearable terminals, car navigation panels, electronic instrument housings, cosmetic and analogous packages, kitchen cabinets, and transportation vehicle bodies are susceptible to deposition of sebum and oil stains on their surface, it is desired to provide their surface with a water repellent and oil repellant layer (water/oil repellent layer). However, fluorinated compounds used as the water/oil repellent agent are non-adhesive or non-bondable to various substrates because of very low surface free energy. It is thus difficult to bond the water/oil repellent agent directly to substrates.

To address the problem of bond or adhesion, as a treating agent capable of water/oil repellent treatment on surfaces of glass and other substrates, for example, Patent Document 1 discloses a fluorooxyalkylene group-containing polymer composition having the following average compositional formula:

A-Rf'-B

wherein Rf¹ is a divalent linear fluorooxyalkylene group containing 5 to 100 repeating units: -C_{d}F_{2d}O- wherein d is an integer of 1 to 6 and may be different among repeating units, A and B are each independently a group selected from Rf² and the following formula: 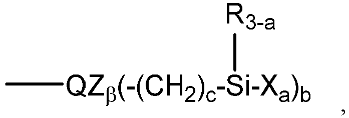
Rf² is F, H, or a monovalent fluorinated group terminated with -CF₃ or -CF₂H group, Q is a divalent organic group, Z is a di- to heptavalent organopolysiloxane residue having a siloxane bond, R is C₁₋₄ alkyl or phenyl, X is a hydrolyzable group, a is 2 or 3, b is an integer of 1 to 6, c is an integer of 1 to 5, and β is an integer of 0 or 1.

The treating agent of Patent Document 1 exhibits relatively good durability, but is still unsatisfactory and in particular, difficult to provide good adhesion to resins, sapphire, ceramics and the like.

As the means for improving adhesion, Patent Document 2 discloses a method of depositing a SiO₂ layer as a primer layer by a dry process like evaporation, sputtering or CVD. It is described that a water/oil repellent layer having good durability is formed on a glass substrate by this method. However, no satisfactory durability is displayed in a severe reliability test like the test of rubbing the surface with an eraser.

On the other hand, Patent Document 3 discloses a polysilazane solution from which a primer layer is deposited by a wet process. After the polysilazane solution is coated, the polysilazane is converted to silica glass through reaction with moisture. Although this method is superior to the dry method in that the vacuum process is not used, no satisfactory durability is displayed in a severe reliability test like the test of rubbing the surface with an eraser.

Moreover, a member having a water/oil repellent layer formed on a substrate by the above method often has a higher surface resistivity than the surface resistivity of the substrate, giving rise to the problem of frequent electric charging. A variety of antistatic agents are thus proposed. Since the antistatic agent is added to a composition, water/oil repellency and antifouling properties at the surface are insufficient. It is difficult for a water/oil repellent surface to meet both high abrasion resistance and antistatic properties.

Patent Document 17 relates to a water/oil repellent article that includes a water/oil repellent layer having good abrasion resistance. The water/oil repellent article comprises a substrate, a water/oil repellent layer comprising a hydrolyzed condensate of a fluorinated compound having a hydrolysable silyl group, and a silicon oxide layer containing alkali metal atoms, wherein the silicon oxide layer is located between the substrate and the water/oil repellent layer. In one embodiment, the silicon oxide in the silicon oxide layer comprises a condensate of silicic acid or a hydrolyzed condensate of an alkoxysilane.

As the prior art technology relating to the present invention, the following documents are cited as well as the above-cited documents.

### PRIOR ART DOCUMENTS

### PATENT DOCUMENTS

| | |
|---|---|
| Patent Document 1: | JP 2011-116947 A |
| Patent Document 2: | WO 2014/097388 A1 |
| Patent Document 3: | WO 2010/038648 A1 |
| Patent Document 4: | JP 2007-197425 A |
| Patent Document 5: | JP 2007-297589 A |
| Patent Document 6: | JP 2007-297543 A |
| Patent Document 7: | JP 2008-088412 A |
| Patent Document 8: | JP 2008-144144 A |
| Patent Document 9: | JP 2010-031184 A |
| Patent Document 10: | JP 2010-047516 A |
| Patent Document 11: | JP 2011-178835 A |
| Patent Document 12: | JP 2014-084405 A |
| Patent Document 13: | JP 2014-105235 A |
| Patent Document 14: | JP 2013-253228 A |
| Patent Document 15: | JP 2014-218639 A |
| Patent Document 16: | WO 2013/121984 A1 |
| Patent Document 17: | WO 2018/235778 A1 |

### SUMMARY OF INVENTION

### TECHNICAL PROBLEM

An object of the invention, which has been made under the above-mentioned circumstances, is to provide a water/oil repellent member having improved eraser abrasion resistance and antistatic properties, and a method for preparing a water/oil repellent member by depositing a water/oil repellent layer having improved antistatic properties on any one of various substrates.

### SOLUTION TO PROBLEM

Making extensive investigations to attain the above object, the inventors have found that a water/oil repellent member comprising a functional film layer (or first layer) formed on any one of various substrates, the functional film layer being composed mainly of silicon dioxide or including an outermost layer of silicon dioxide, a primer layer (or second layer) disposed on the outer surface of the functional film layer, composed mainly of an organosilicon compound having a plurality of silanol groups in the molecule, and having a specific thickness, and a water/oil repellent layer (or third layer) disposed on the outer surface of the primer layer, composed mainly of a cured product of a hydrolyzable fluorinated compound, and having a specific thickness, is obtained by a method comprising the steps of forming a functional film layer on at least one surface of a substrate, the functional film layer being composed mainly of silicon dioxide or including at least an outermost layer of silicon dioxide, wet coating a solution of an organosilicon compound having a plurality of silanol groups in its molecule in a solvent, evaporating the solvent to form a primer layer on the at least one surface of the substrate, wet coating a solution of a hydrolyzable fluorinated compound in a solvent onto the outer surface of the primer layer and evaporating the solvent, or dry coating onto the outer surface of the primer layer the hydrolyzable fluorinated compound obtained by evaporating the solvent from the solution, and curing the hydrolyzable fluorinated compound to form and lay a water/oil repellent layer on the outer surface of the primer layer; that the water/oil repellent member has improved eraser abrasion resistance and antistatic properties (i.e., the surface resistivity on the outer surface is lower by at least 10 Ω/□ than in the absence of the second layer), and the invention can endow various substrates with a water/oil repellent coating having the improved functions of eraser abrasion resistance and antistatic properties (i.e., the surface resistivity on the outer surface is lower by at least 10 Ω/□ than in the absence of the second layer) in a consistent simple manner. The invention is predicated on this finding and is defined in the claims.

In a first aspect, the invention thus relates to a water repellent and oil repellent member as defined in claim 1. The water repellent and oil repellent member comprises
a substrate,
a functional film layer disposed on at least one surface of the substrate as a first layer,
a primer layer disposed on the outer surface of the functional film layer as a second layer, and
a water repellent and oil repellent layer disposed on the outer surface of the primer layer as a third layer,
wherein the functional film layer is a silicon dioxide layer having a thickness of 10 to 500 nm or has a multilayer structure which includes at least an outermost layer composed of silicon dioxide and having a thickness of 10 to 500 nm,
wherein the primer layer is a layer composed mainly of an organopolysiloxane compound having a plurality of silanol groups in the molecule and having a thickness of 10 to 500 nm, the organopolysiloxane compound having a plurality of silanol groups in the molecule being a hydrolytic partial condensate of a tetraalkoxysilane and having a silanol content of 0.002 to 0.042 mol/g, and
wherein the water repellent and oil repellent layer is a layer composed mainly of a cured product of a hydrolyzable fluorinated compound and having a thickness of 0.5 to 50 nm.

In a second aspect, the invention relates to a method for preparing the water repellent and oil repellent member of the first aspect. The method comprises the steps of:
forming a functional film layer on at least one surface of a substrate, the functional film layer being a silicon dioxide layer having a thickness of 10 to 500 nm or having a multilayer structure which includes at least an outermost layer composed of silicon dioxide and having a thickness of 10 to 500 nm,
wet coating a solution of an organopolysiloxane compound having a plurality of silanol groups in the molecule in a solvent onto the outer surface of the functional film layer, and then evaporating the solvent to form and lay a primer layer having a thickness of 10 to 500 nm on at least one surface of the substrate, the organopolysiloxane compound having a plurality of silanol groups in the molecule being a hydrolytic partial condensate of a tetraalkoxysilane and having a silanol content of 0.002 to 0.042 mol/g, and
wet coating a solution of a hydrolyzable fluorinated compound in a solvent onto the outer surface of the primer layer and then evaporating the solvent, or evaporating off the solvent from the solution and dry coating the hydrolyzable fluorinated compound onto the outer surface of the primer layer, and curing the hydrolyzable fluorinated compound to form and lay a water repellent and oil repellent layer on the outer surface of the primer layer.

It is noted that the "linear perfluorooxyalkylene polymer residue" as used herein means that the divalent fluorooxyalkylene repeating units by which the backbone perfluorooxyalkylene structure is constructed are linearly linked. It is acceptable that individual divalent fluorooxyalkylene units themselves be fluorooxyalkylene units having a branched structure such as -[CF₂CF(CF₃)O]-.

### ADVANTAGEOUS EFFECTS OF INVENTION

According to the invention, there is provided a water/oil repellent member meeting both antistatic and water/oil repellent properties on its surface and having improved eraser abrasion resistance. The method for preparing the water/oil repellent member enables to form the relevant layers by the vacuum process or the wet process (e.g., brush coating, spin coating, spraying, gravure coating, die coating, bar coating or slit coating). The water/oil repellent member and the method are useful in a variety of applications, especially the application where the surface comes in contact with fingers or tools, for example, articles whose function can be lost by electrostatic charges, typically touch panel displays, flexible displays, electronic instrument housings, wearable terminals, eyeglass lenses, protective films, protective glass, glass for copiers, vehicle mount cameras, radar covers for automatic driving, quartz glass for semiconductor part manufacture, and the like, articles which should avoid a loss of visibility and flaws by electrostatic deposition of dust and debris, articles whose visibility and aesthetic appearance are degraded by deposition of fingerprints, oil or water, and articles in which fur and stains are deposited from water and removed by rubbing, typically kitchen sinks, faucets, and shower heads.

### DESCRIPTION OF EMBODIMENTS

Now the invention is described in detail.

The invention provides a water/oil repellent member comprising a substrate, a functional film layer disposed on at least one surface of the substrate as a first layer, a primer layer disposed on the outer surface of the functional film layer as a second layer, and a water/oil repellent layer disposed on the outer surface of the primer layer as a third layer, wherein the primer layer is a layer composed mainly of an organosilicon compound having a plurality of silanol groups in the molecule and having a thickness of 10 to 500 nm, and the water/oil repellent layer is a layer composed mainly of a cured product of a hydrolyzable fluorinated compound and having a thickness of 0.5 to 50 nm.

According to the invention, for example, by a method comprising the steps of forming a functional film layer (first layer) on a surface (at least one surface) of any one of various substrates, the functional film layer being composed mainly of silicon dioxide or including at least an outermost layer of silicon dioxide, wet coating a solution of an organosilicon compound having a plurality of silanol groups in the molecule in a solvent onto the outer surface of the functional film layer and then evaporating the solvent to form and lay a primer layer (second layer) on the functional film layer, wet coating a solution of a hydrolyzable fluorinated compound in a solvent (water/oil repellent agent) onto the outer surface of the primer layer and then evaporating the solvent, or dry coating the hydrolyzable fluorinated compound obtained by evaporating the solvent from the solution (water/oil repellent agent) onto the outer surface of the primer layer, and curing the hydrolyzable fluorinated compound to form a water/oil repellent layer (third layer) on the outer surface of the primer layer, there is obtained a water/oil repellent member comprising a primer layer disposed on the surface of a substrate, composed mainly of an organosilicon compound having a plurality of silanol groups in the molecule, and having a thickness of 10 to 500 nm, and a water/oil repellent layer disposed on the surface of the primer layer, composed mainly of a cured product of a hydrolyzable fluorinated compound, and having a thickness of 0.5 to 50 nm.

The substrate which can be used herein is not particularly limited and is preferably selected from resins, ceramics, metals, quartz, glass, sapphire, and diamond.

Suitable substrate-forming resins include thermoplastic resins and thermosetting resins. Specifically stated, suitable thermoplastic resins include celluloid, cellulose acetate, cellulose propionate, cellulose butyrate, triacetyl cellulose, aliphatic polyamides such as nylon 6, nylon 66, nylon 12, aromatic polyamides, ABS resins, AS resins, polystyrene, polyolefins such as polyethylene (low density or high density) and polypropylene, cycloolefin polymers, polyvinyl chloride, polyvinylidene chloride, ethylene-vinyl acetate copolymers, polyvinyl alcohol, polyacetal, saturated polyesters such as polycarbonate, polyethylene terephthalate, and polybutylene terephthalate, aromatic polyesters, polyether ketones, polyether ether ketones, polysulfone, polyether sulfone, polyether imide, polyarylate, polymethylpentene, ionomers, liquid crystal polymers, polyimides, polyamide imides, fluoro-resins, polyphenylene sulfide, (modified) polyphenylene oxide, and thermoplastic polyurethane. Suitable thermosetting resins include epoxy resins, unsaturated polyesters, thermosetting polyurethane, polyimide, diethylene glycol bisallyl carbonate polymers (commonly known as CR-39), (co)polymers of di(meth)acrylate of (halogenated) bisphenol A, (co)polymers of urethane-modified di(meth)acrylate of (halogenated) bisphenol A, and copolymers of diacrylate compounds or vinyl benzyl alcohol with unsaturated thiol compounds.

The functional film layer formed and laid on at least one surface of the substrate is such a functional film layer as a hard coat layer, antireflective layer or IR cutoff filter layer. The function of the functional film layer is not limited to these functions. It suffices that the functional film layer is in its entirety composed of silicon dioxide, or includes at least an outermost layer composed of silicon dioxide. According to the invention, the entire functional film layer (silicon dioxide layer) or the outermost layer (silicon dioxide layer) of the functional film layer has a thickness of the order of 10 to 500 nm, preferably 10 to 150 nm.

Specifically, the functional film layer is a hard coat layer composed of a silicon dioxide layer, a hard coat layer of two, three or multilayer structure including a hard coat layer and a silicon dioxide layer formed thereon, an antireflective layer of two, three or multilayer structure having an outermost layer of silicon dioxide formed on a substrate, an IR cutoff filter layer of two, three or multilayer structure having an outermost layer of silicon dioxide formed on a substrate, or the like.

The primer layer formed and laid on the outer surface of the functional film layer is composed mainly of an organosilicon compound having a plurality of silanol groups in the molecule, preferably at least 50% by weight of the organosilicon compound, and has a thickness of 10 to 500 nm. The primer layer may be formed or laminated, for example, by wet coating a solution of an organosilicon compound having a plurality of silanol groups in the molecule in a solvent onto the outer surface of the functional film layer, and evaporating off the solvent.

The organosilicon compound having a plurality of silanol groups in the molecule should preferably have at least two, more preferably at least three, and even more preferably at least four silanol groups per molecule. If the number of silanol groups per molecule is too small, the adhesion of the primer layer to the inner surface of the water/oil repellent layer to be laid on the outer surface of the primer layer may be aggravated or the surface resistivity may not become low. According to the invention, the organosilicon compound having a plurality of silanol groups in the molecule has a silanol content of 0.002 to 0.042 mol/g, preferably 0.004 to 0.035 mol/g, and more preferably 0.005 to 0.030 mol/g.

The organosilicon compound having a plurality of silanol groups in the molecule is obtained from hydrolysis and partial condensation of an organosilicon compound having a plurality of hydrolyzable alkoxy groups, e.g. methoxy or ethoxy groups, in the molecule.

In the practice of the invention, a higher molecular weight product (partial condensate) obtained by hydrolyzing an organosilicon compound having a plurality of hydrolyzable alkoxy groups and effecting partial dehydrating condensation is used as the organosilicon compound having a plurality of silanol groups in the molecule. As used herein, the partial condensate refers to an organopolysiloxane compound having a plurality of residual silanol groups in the molecule, which is obtained from hydrolysis of an organosilicon compound having a plurality of hydrolyzable alkoxy groups and subsequent partial dehydrating condensation of the resulting organosilane having a plurality of silanol groups (silicon-bonded hydroxy groups) in the molecule.

The hydrolytic partial condensate (i.e., organosilicon compound having a plurality of silanol groups in the molecule) obtained from the organosilicon compound having a plurality of hydrolyzable groups in the molecule should preferably have a weight average molecular weight of 300 to 100,000, more preferably 5,000 to 50,000. As used herein, the weight average molecular weight may be determined, for example, by gel permeation chromatography (GPC) using toluene as developing solvent versus polystyrene standards (the same holds true, hereinafter).

According to the invention, the organosilicon compound having a plurality of silanol groups in the molecule is a hydrolytic partial condensate of a tetraalkoxysilane such as tetramethoxysilane or tetraethoxysilane.

The organosilicon compound having a plurality of silanol groups in the molecule is desirably diluted with a solvent. Preferred examples of the solvent for diluting the organosilicon compound having a plurality of silanol groups in the molecule include alcohols such as methanol, ethanol, isopropanol and butanol, and ethers such as propylene glycol monomethyl ether and polyethylene glycol monopropyl ether, but are not limited thereto. An appropriate solvent may be selected in view of wetting of the first layer and boiling point. The solution of the organosilicon compound having a plurality of silanol groups in the molecule in a solvent should preferably contain the organosilicon compound in a concentration of 0.01 to 10% by weight, more preferably 0.6 to 4% by weight. If the concentration is too low, more portions may be left uncoated. If the concentration is too high, secondary agglomeration can take place between silanol groups.

In the solution of the organosilicon compound having a plurality of silanol groups in the molecule in a solvent, additives such as UV absorbers, photo-stabilizers, antioxidants, leveling agents, anti-foaming agents, pigments, dyes, dispersants, antistatic agents, anti-fogging agents, and surfactants may be used if necessary. The optional additives are preferably added in such amounts that the organosilicon compound having a plurality of silanol groups in the molecule may account for at least 50% by weight (50 to 100% by weight), especially 80 to 100% by weight of the primer layer obtained after removal of the solvent whereas the additives account for up to 50% by weight (0 to 50% by weight), especially 0 to 20% by weight.

A primer layer composed mainly of the organosilicon compound having a plurality of silanol groups in the molecule may be formed by coating the solution of the organosilicon compound having a plurality of silanol groups in the molecule in a solvent onto the outer surface of the functional film layer by a wet coating process, specifically dipping, brush coating, spin coating, spray coating, gravure coating, die coating, bar coating, slit coating or flow coating, and then evaporating off the solvent. If desired, the coating may be heated at a temperature in the range which does not affect the substrate, for example, at 40 to 500°C for 10 seconds to 24 hours.

The primer layer formed and laid on the outer surface of the functional film layer typically has a thickness of 10 to 500 nm, preferably 30 to 400 nm, more preferably 30 to 250 nm. As used herein, the thickness of a layer may be measured by any well-known methods such as spectral ellipsometry and X-ray reflection method (the same holds true, hereinafter).

Next, the water/oil repellent layer which is formed and laid on the outer surface of the primer layer is a layer composed mainly of a cured product of a hydrolyzable fluorinated compound and having a thickness of 0.5 to 50 nm.

The water/oil repellent layer may be formed and laid on the primer layer, for example, by coating a solution of a hydrolyzable fluorinated compound in a solvent (water/oil repellent agent) onto the outer surface of the primer layer and curing the agent.

The hydrolyzable fluorinated compound used herein may be selected from the hydrolyzable fluorinated organosilicon compounds which are described in JP 2007-197425 A, JP 2007-297589 A, JP 2007-297543 A, JP 2008-088412 A, JP 2008-144144 A, JP 2010-031184 A, JP 2010-047516 A, JP 2011-116947 A, JP 2011-178835 A, JP 2014-084405 A, JP 2014-105235 A, JP 2013-253228 A, JP 2014-218639 A, and WO 2013/121984 A1 (Patent Documents 1, 4 to 16).

The hydrolyzable fluorinated compound is described in further detail.

The hydrolyzable fluorinated compound used herein is preferably a hydrolyzable fluorinated compound having at least one, preferably 1 to 6, more preferably 1 to 4 hydrolyzable silyl groups (for example, silyl groups having 1 to 3 silicon-bonded hydrolyzable groups such as alkoxy groups, e.g., trialkoxysilyl, dialkoxy(organo)silyl or alkoxy(diorgano)silyl groups) at each of one or more ends, preferably 1 to 14 ends, more preferably 1 to 7 ends of the molecular chain (for example, having at least one, preferably 1 to 20, more preferably 2 to 14, even more preferably 2 to 8 hydrolyzable silyl groups per molecule). More preferably the compound is an organosilicon compound having a hydrolyzable silyl group and fluorine in the molecule, the hydrolyzable silyl group being selected from hydrolyzable silyl groups each having 1 to 3 hydrolyzable groups, for example, C₁₋₁₂, especially C₁₋₁₀ alkoxy groups such as methoxy, ethoxy, propoxy and butoxy, C₂₋₁₂, especially C₂₋₁₀ alkoxyalkoxy groups such as methoxymethoxy and methoxyethoxy, C₁₋₁₀ acyloxy groups such as acetoxy and propionoxy, C₂₋₁₀ alkenyloxy groups such as vinyloxy and isopropenoxy, halogen groups such as chloro, bromo and iodo, primary or secondary amino groups, and silazane groups.

The hydrolyzable fluorinated compound is preferably a compound having a fluorooxyalkylene group (i.e., mono- or divalent perfluoropolyether residue) in the molecule. The fluorooxyalkylene group refers to a compound of (poly)fluorooxyalkylene structure (i.e., divalent linear perfluorooxyalkylene polymer residue) having a plurality of repeating units: -CⱼF₂ⱼO- bonded wherein j is an integer of at least 1, preferably 1 to 6, more preferably 1 to 4. Especially, the structure may have 3 to 500, preferably 15 to 200, more preferably 20 to 100, even more preferably 25 to 80 repeating units.

The repeating units: -CⱼF₂ⱼO- may be linear or branched. Examples include the following units while repeating units of more than one type may be bonded.

-CF₂O-

-CF₂CF₂O-

-CF₂CF₂CF₂O-

-CF(CF₃)CF₂O-

-CF₂CF₂CF₂CF₂O-

-CF₂CF₂CF₂CF₂CF₂O-

-C(CF₃)₂O-

Most preferably, the (poly)fluorooxyalkylene structure (i.e., divalent linear perfluorooxyalkylene polymer residue) is -(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-, wherein p, q, r, s, and t are each independently an integer of 0 to 200, preferably p is an integer of 5 to 100, q is an integer of 5 to 100, r is an integer of 0 to 100, s is an integer of 0 to 50, t is an integer of 0 to 100, and p+q+r+s+t is an integer of 3 to 500, preferably an integer of 10 to 105. Each unit in parentheses may be randomly arranged. The subscript d is independently an integer of 0 to 8, preferably an integer of 0 to 5, more preferably an integer of 0 to 2, and the unit with d may be linear or branched. Specific examples are shown by the following structures.

-(CF₂)_{d'}-O-(CF₂CF₂O)_{q'}-(CF₂)_{d'}-

-(CF₂)_{d'}-O-(CF₂CF₂CF₂O)_{r'}-(CF₂)_{d'}-

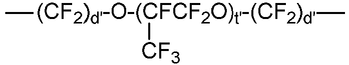

-(CF₂)_{d'}-O-(CF₂O)_{p'}(CF₂CF₂O)_{q'}-(CF₂)_{d'}-

-(CF₂)_{d'}-O-(CF₂O)_{p'}(CF₂CF₂O)_{q'}(CF₂CF₂CF₂O)_{r'}-(CF₂)_{d'}-

-(CF₂)_{d'}-O-(CF₂O)_{p'}(CF₂CF₂O)_{q'}(CF₂CF₂CF₂CF₂O)_{s'}-(CF₂)_{d'}-

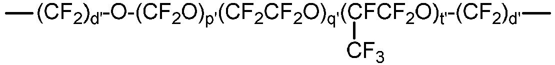

-(CF₂)_{d'}-O-(CF₂O)_{p'}(CF₂CF₂O)_{q'}(CF₂CF₂CF₂O)_{r'}(CF₂CF₂CF₂CF₂O)_{s'}-(CF₂)_{d'}-

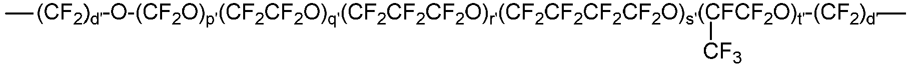

- (CF₂)_{d'}-O-(CF₂CF₂O)_{q'}(CF₂CF₂CF₂CF₂O)_{s'}-(CF₂)_{d'}-

Herein p', q', r', s', and t' are each independently an integer of 1 to 200, the sum of p', q', r', s', and t' is 3 to 500, each unit in parentheses may be randomly arranged, d' is independently an integer of 0 to 5, and the unit with d' may be linear or branched.

More preferably, the hydrolyzable fluorinated compound used herein is a hydrolyzable fluorinated organosilicon compound (or hydrolyzable fluorine-containing organosilicon compound) having any one of the general formulae (1) to (5). The compounds may be used alone or in admixture.

(A-Rf)_{α}-ZW_{β} (1)

Rf-(ZW_{β})₂ (2)

Z'-(Rf-ZW_{β})_{γ} (3)

A-Rf-Q-(Y)_{δ}-B (4)

Rf-(Q-(Y)_{δ}-B)₂ (5)

In formulae (1) to (5), Rf is a divalent linear perfluorooxyalkylene polymer residue: -(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-, p, q, r, s, and t are each independently an integer of 0 to 200, p+q+r+s+t is 3 to 500, each repeating unit in parentheses may be randomly arranged, d is an integer of 0 to 8, the unit with d may be linear or branched. "A" is fluorine, hydrogen or a monovalent fluorinated group terminated with -CF₃, -CF₂H or -CH₂F group, Z and Z' are each independently a single bond, or a di- to octavalent organic group which may contain nitrogen, oxygen, silicon, phosphorus or sulfur and which may be fluorinated, W is a monovalent organic group terminated with a hydrolyzable group. The subscripts α and β are each independently an integer of 1 to 7, preferably α is an integer of 1 to 3, more preferably 1, β is an integer of 1 to 3, α+β is an integer of 2 to 8, preferably an integer of 2 to 4, and γ is an integer of 2 to 8, preferably 2 or 3.

Q is a single bond or divalent organic group, δ is independently an integer of 1 to 10, Y is a divalent organic group having a hydrolyzable group, and B is hydrogen, C₁₋₄ alkyl or halogen.

In formulae (1) to (5), Rf is the above-described (poly)fluorooxyalkylene structure (divalent linear perfluorooxyalkylene polymer residue):

-(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-,

examples of which are as illustrated above.

In formulae (1) and (4), "A" is fluorine, hydrogen or a monovalent fluorinated group terminated with -CF₃, -CF₂H or -CH₂F group. Examples of the monovalent fluorinated group terminated with -CF₃, -CF₂H or -CH₂F group include -CF₃, -CF₂CF₃, -CF₂CF₂CF₃, -CH₂CF(CF₃)-OC₃F₇, and -CH₂OCF₂CFH-OC₃F₇. Inter alia, A is preferably -CF₃, -CF₂CF₃, -CF₂CF₂CF₃, or -CH₂OCF₂CFH-OC₃F₇.

In formulae (1) to (3), Z and Z' are each independently a single bond, or a di- to octavalent organic group which may contain nitrogen, oxygen, silicon, phosphorus or sulfur and which may be fluorinated. The organic group may be represented by (L)ₑ-M wherein e is an integer of 1 to 7, preferably 1 to 3.

Herein L is a single bond, oxygen, sulfur or a divalent organic group. In formulae (1) to (3), L in Z is a linking group between Rf group and M group (or W group), and L in Z' is a linking group between M group (or Rf group) and Rf group. The divalent organic group is preferably an unsubstituted or substituted C₂₋₁₂ divalent organic group which may contain one or more selected from the group consisting of amide bond, ether bond, carbonyl bond, ester bond, diorganosilylene groups such as dimethylsilylene, and groups of the formula: -Si[OH][(CH₂)_{f}Si(CH₃)₃]- wherein f is an integer of 2 to 4, more preferably an unsubstituted or substituted C₂₋₁₂ divalent hydrocarbon group which may contain the foregoing structure.

Examples of the unsubstituted or substituted C₂₋₁₂ divalent hydrocarbon group include alkylene groups such as ethylene, propylene (trimethylene or methylethylene), butylene (tetramethylene or methylpropylene), hexamethylene, and octamethylene, arylene groups such as phenylene, and combinations of two or more such groups, such as alkylene-arylene groups. In these groups, some or all of the carbon-bonded hydrogen atoms may be substituted by halogen atoms such as fluorine and iodine. Inter alia, unsubstituted or substituted C₂₋₄ alkylene groups or phenylene groups are preferred.

Examples of the divalent organic group L include groups of the following structure, and combinations of two or more such groups.

-(CH₂)ᵤ-O-(CH₂)ᵥ-

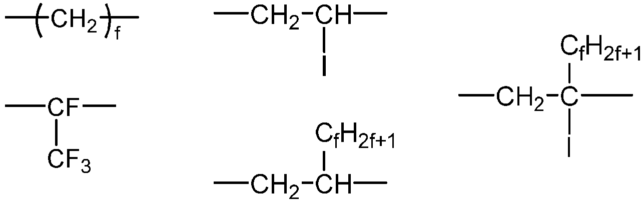

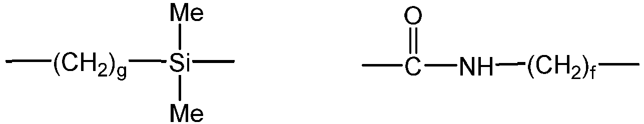

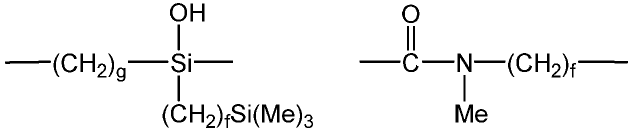

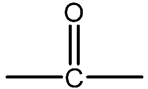

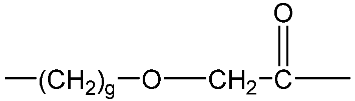

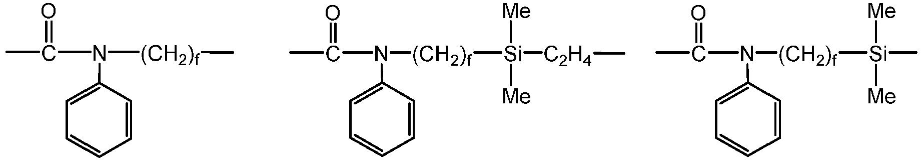

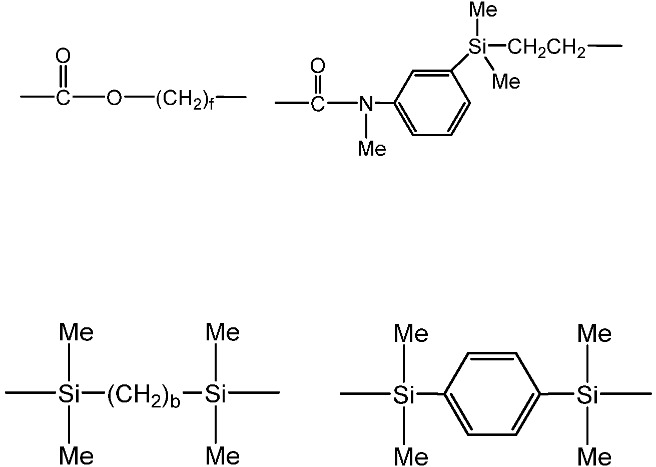

Herein f is an integer of 2 to 4, b is an integer of 2 to 6, preferably 2 to 4, u and v each are an integer of 1 to 4, g is an integer of 2 to 4, and Me is methyl.

Also, M is a single bond, nitrogen, silicon, carbon, phosphorus, or a di- to octavalent, i.e., (e+1)-valent organic group containing such atom. Specifically, M is a single bond, divalent group -R¹₂C-, divalent group -R³₂Si-, divalent group -NR⁴-, trivalent group -N= (including trivalent group of isocyanuric ring structure), trivalent group -P=, trivalent group -PO=, trivalent group -R¹C=, trivalent group -R³Si=, tetravalent group -C≡, tetravalent group -O-C≡, tetravalent group -Si≡, or di- to octavalent siloxane residues. In formulae (1) to (3), M in Z is a linking group between L (or Rf group) and W group, and M in Z' is a group to link with Rf group via L (or Rf groups together).

Herein, R¹ is each independently a C₁₋₃ alkyl group, hydroxy group, group having repeating unit of C₁₋₃ oxyalkylene group which may have an intervening diorganosiloxane structure of 2 to 51 silicon atoms, or silyl ether group represented by R²₃SiO-. R² is each independently hydrogen, a C₁₋₃ alkyl group, aryl group such as phenyl, or C₁₋₃ alkoxy group. R³ is each independently a C₁₋₃ alkyl group, C₂ or C₃ alkenyl group, C₁₋₃ alkoxy group, or chloro. R⁴ is a C₁₋₃ alkyl group or C₆₋₁₀ aryl group such as phenyl. When M is a siloxane residue, it preferably has a straight, branched or cyclic organopolysiloxane structure of 2 to 51 silicon atoms, preferably 2 to 13 silicon atoms, more preferably 2 to 11 silicon atoms, even more preferably 2 to 5 silicon atoms. The organopolysiloxane having an unsubstituted or fluorinated alkyl group of 1 to 8 carbon atoms, more preferably 1 to 4 carbon atoms such as methyl, ethyl, propyl, butyl or C₃F₇-C₃H₆-, or phenyl group is preferred. The organopolysiloxane may also contain a silalkylene structure in which two silicon atoms are linked by an alkylene group, that is, Si-(CH₂)ₙ-Si wherein n is an integer of 2 to 6, preferably an integer of 2 to 4.

The following are exemplary of M defined above. 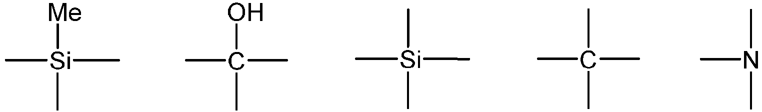 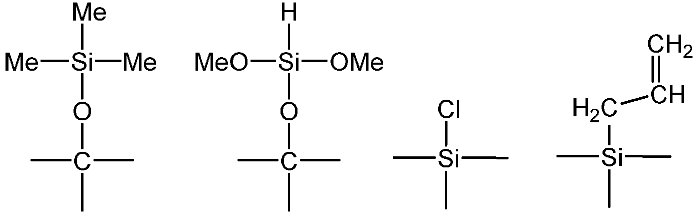 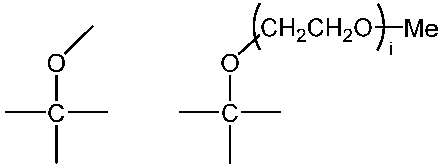 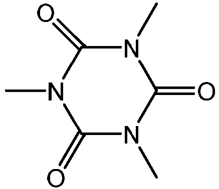 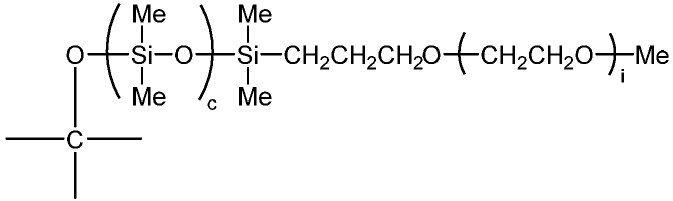 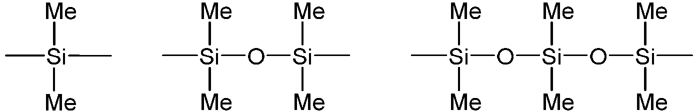 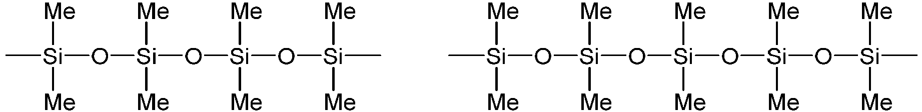 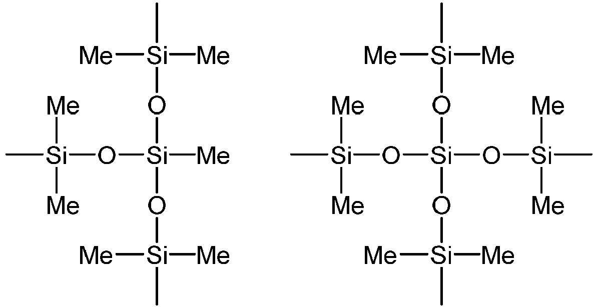 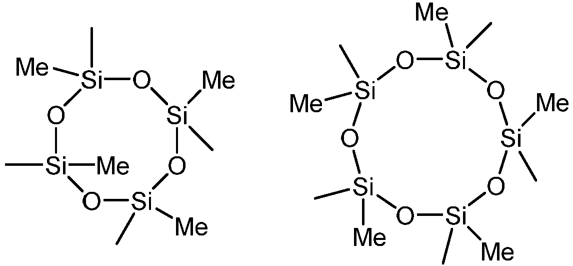 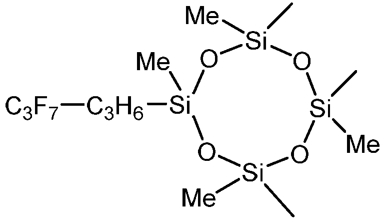 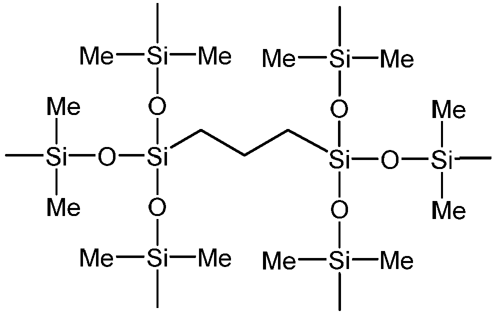 Herein i is an integer of 1 to 20, c is an integer of 1 to 50, and Me is methyl.

In formulae (1) to (3), W is a monovalent organic group terminated with a hydrolyzable group, preferably represented by the following formula. 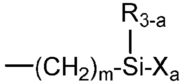 Herein R is C₁₋₄ alkyl or phenyl, X is a hydrolyzable group, a is 2 or 3, and m is an integer of 0 to 10.

In the above formula, examples of the hydrolyzable group X include alkoxy groups of 1 to 12 carbon atoms, especially 1 to 10 carbon atoms such as methoxy, ethoxy, propoxy and butoxy, alkoxyalkoxy groups of 2 to 12 carbon atoms, especially 2 to 10 carbon atoms such as methoxymethoxy and methoxyethoxy, acyloxy groups of 1 to 10 carbon atoms such as acetoxy, alkenyloxy groups of 2 to 10 carbon atoms such as isopropenoxy, halogen groups such as chloro, bromo and iodo, and amino groups. Inter alia, methoxy and ethoxy groups are preferred.

R is C₁₋₄ alkyl such as methyl or ethyl, or phenyl, with methyl being preferred.

The subscript "a" is 2 or 3. From the standpoints of reactivity and adhesion to the primer layer, "a" is preferably equal to 3. The subscript m is an integer of 0 to 10, preferably an integer of 2 to 8, more preferably 2 or 3.

In formulae (1) to (3), examples of the structure represented by -ZW_{β} include the following structures. 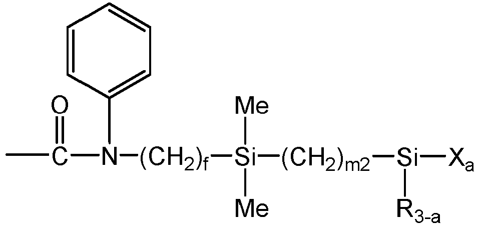 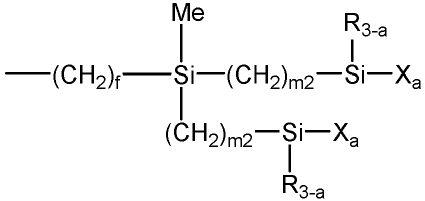 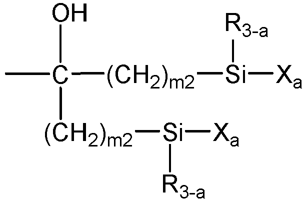 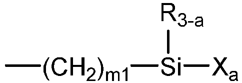 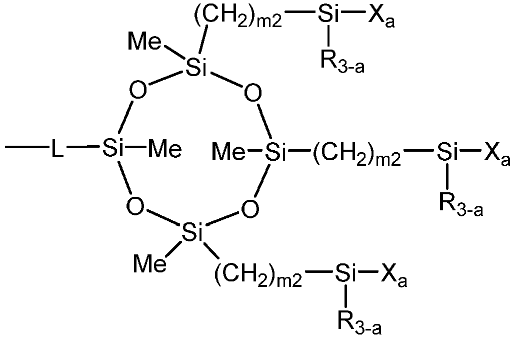 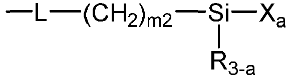 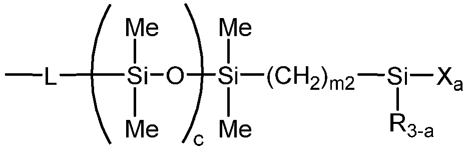 Herein, L, R, X, f, c, and a are as defined above; m1 is an integer of 0 to 10, preferably an integer of 2 to 8, m2 is an integer of 1 to 10, preferably an integer of 2 to 8, and Me is methyl.

In formulae (4) and (5), Q is a single bond or divalent organic group, that is a linking group between Rf group and Y group. The divalent organic group represented by Q is preferably an unsubstituted or substituted C₂₋₁₂ divalent organic group which may contain at least one structure selected from amide bond, ether bond, ester bond, diorganosilylene groups such as dimethylsilylene, and groups represented by -Si[OH][(CH₂)_{f}Si(CH₃)₃]-wherein f is an integer of 2 to 4, more preferably an unsubstituted or substituted C₂₋₁₂ divalent hydrocarbon group which may contain the aforementioned structure.

Examples of the unsubstituted or substituted C₂₋₁₂ divalent hydrocarbon group are as exemplified above for the unsubstituted or substituted C₂₋₁₂ divalent hydrocarbon group L.

Examples of the divalent organic group Q include groups of the following structure. 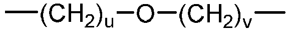 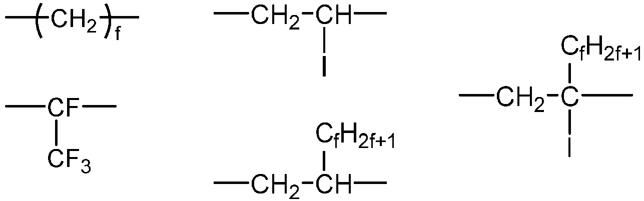 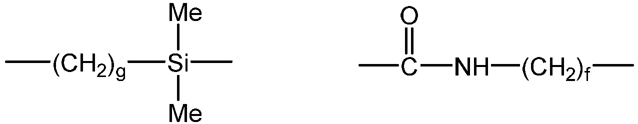 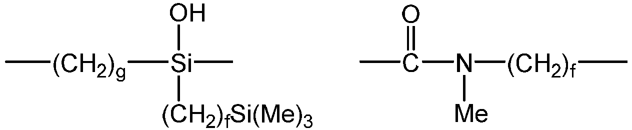 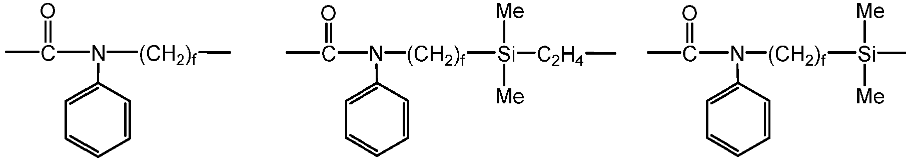 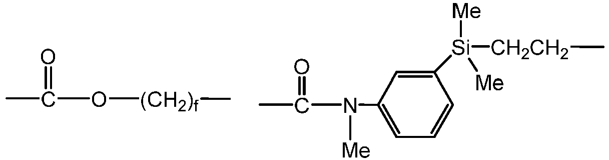 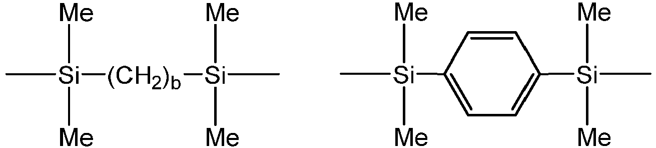 Herein f is an integer of 2 to 4, b is an integer of 2 to 6, preferably 2 to 4, u and v each are an integer of 1 to 4, g is an integer of 2 to 4, and Me is methyl.

In formulae (4) and (5), Y is each independently a divalent organic group having a hydrolyzable group, preferably a group of the following formula. 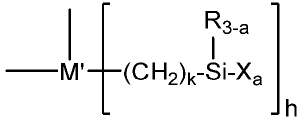 Herein R, X, and a are as defined above; k is an integer of 0 to 10, preferably an integer of 1 to 10, more preferably an integer of 2 to 8; h is an integer of 1 to 6, preferably 1 or 2. M' is an unsubstituted or substituted tri- to octavalent, preferably tri- or tetravalent hydrocarbon group, in which some or all of the carbon atoms may be replaced by silicon atoms and some or all of the carbon-bonded hydrogen atoms may be substituted by halogen atoms such as fluorine.

Preferably M' is selected from groups of the following structures. 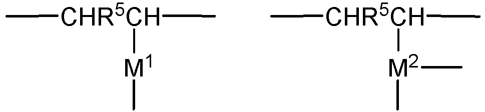 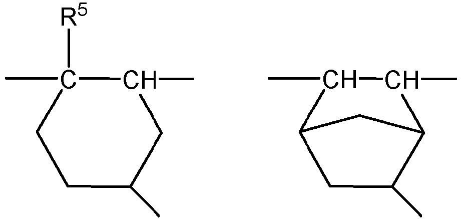 Herein M¹ is a single bond, unsubstituted or substituted C₁₋₆ divalent hydrocarbon group, or diorganosilylene group such as dimethylsilylene. M² is a trivalent group of the formula: -R¹C= or trivalent group of the formula: -R³Si=. R¹ and R³ are as defined above. R⁵ is hydrogen or a monovalent hydrocarbon group, typically C₁₋₆ alkyl group such as methyl, ethyl or propyl.

Exemplary of M¹ are a single bond, phenylene, dimethylsilylene and tetrafluoroethylene. The following is typical of M². 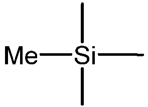 Herein Me is methyl.

For example, Y is selected from the following groups. 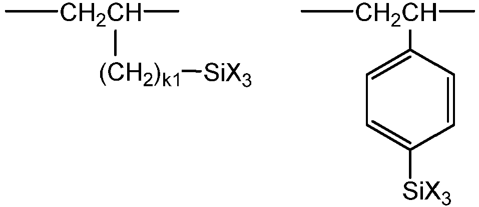 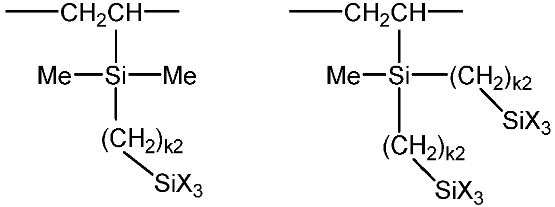 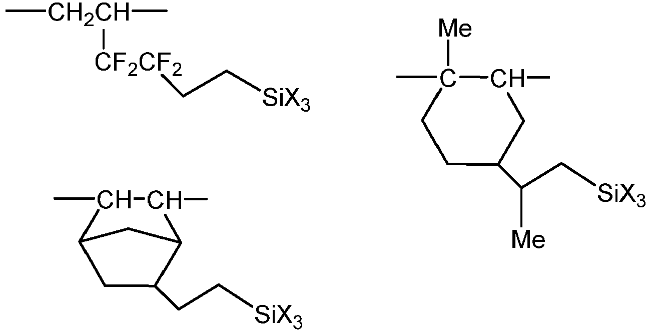 Herein X is as defined above, k1 is an integer of 0 to 10, preferably an integer of 1 to 8, k2 is an integer of 2 to 10, preferably an integer of 2 to 8, and Me is methyl.

In formulae (4) and (5), δ is an integer of 1 to 10, preferably an integer of 1 to 4.

B is each independently selected from hydrogen, C₁₋₄ alkyl groups such as methyl, ethyl, propyl and butyl, and halogen atoms such as fluorine, chlorine, bromine and iodine.

Examples of the hydrolyzable fluorinated organosilicon compounds (hydrolyzable fluorine-containing organosilicon compounds) having formulae (1) to (5) include the structures shown below. 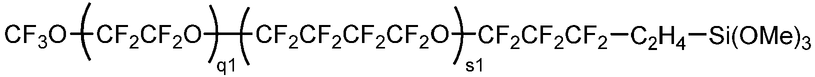 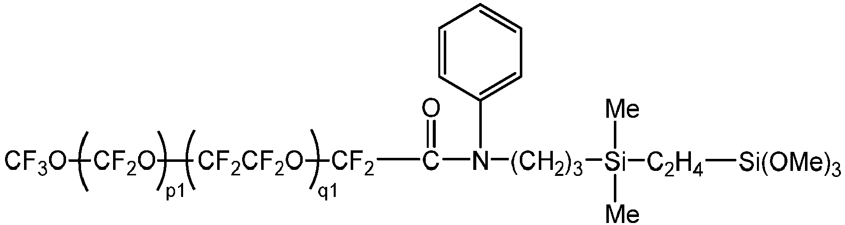 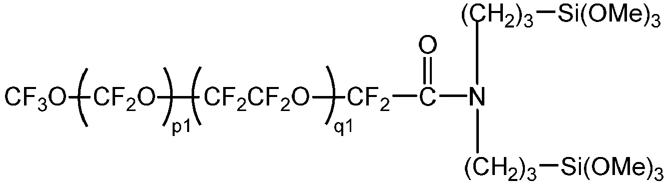 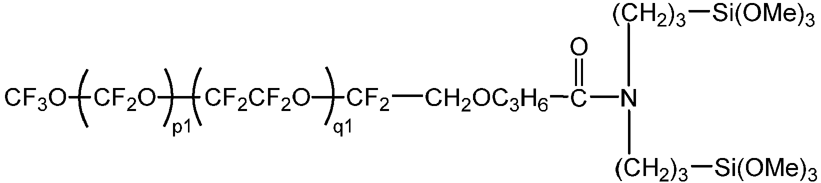 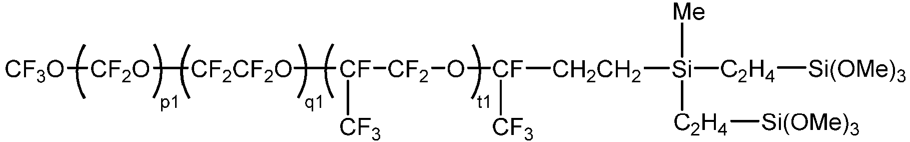 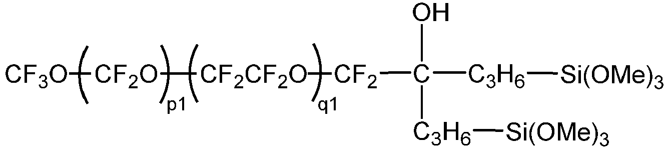 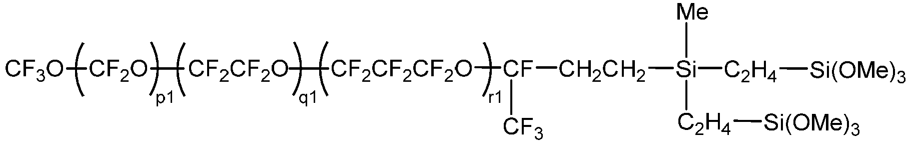 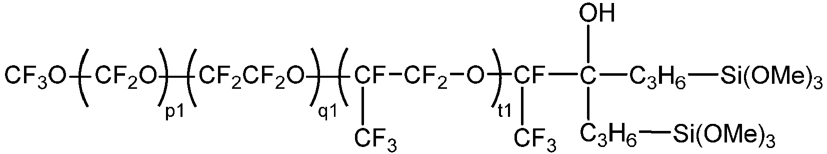 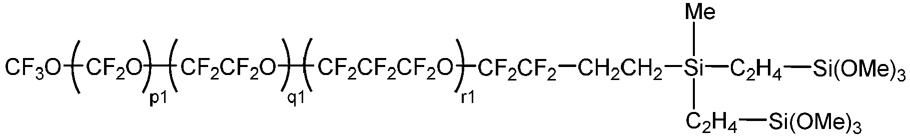 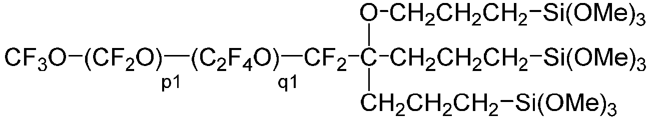 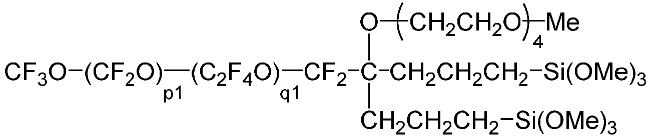 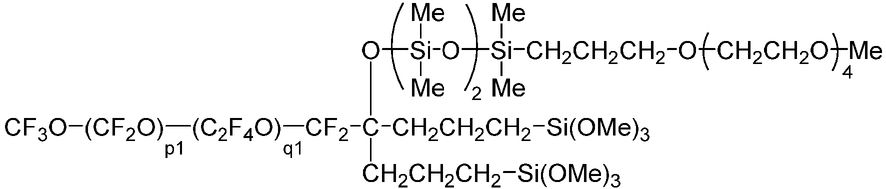 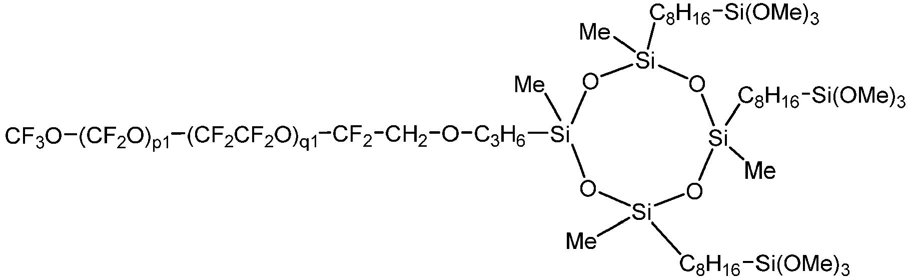 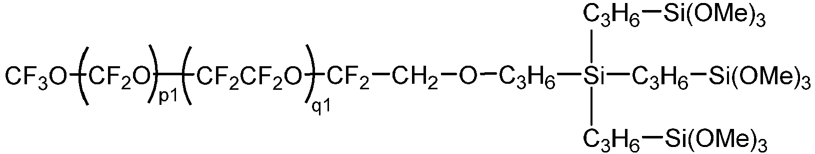 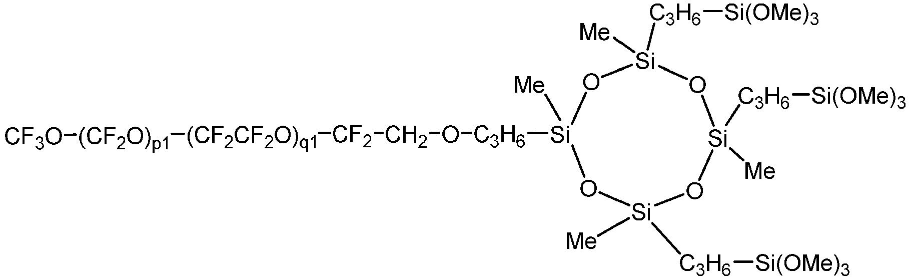 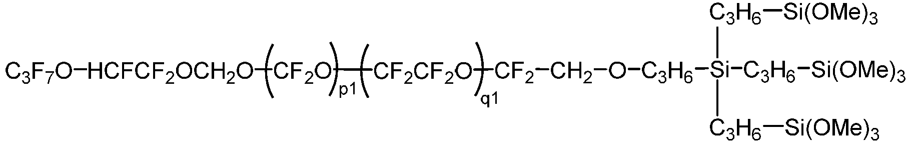 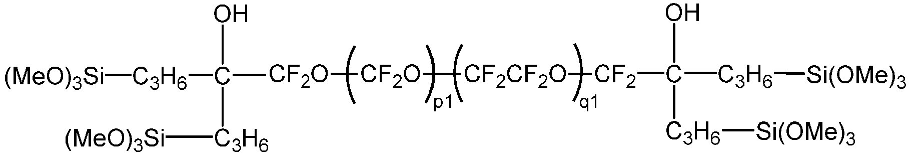 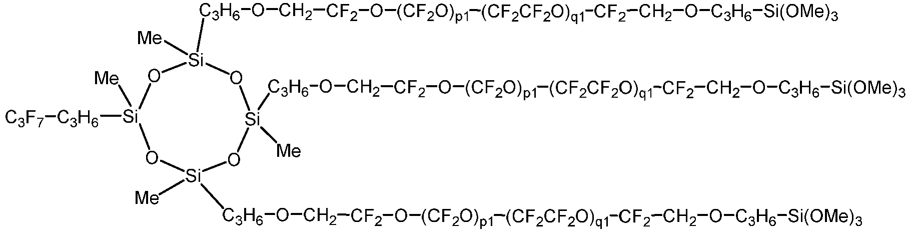 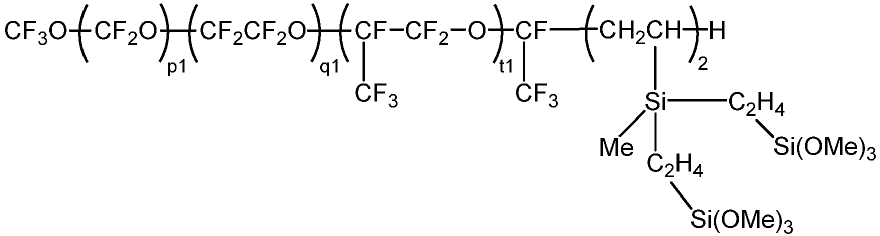 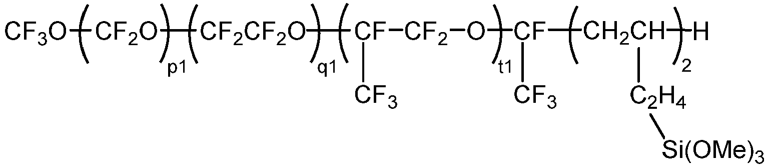 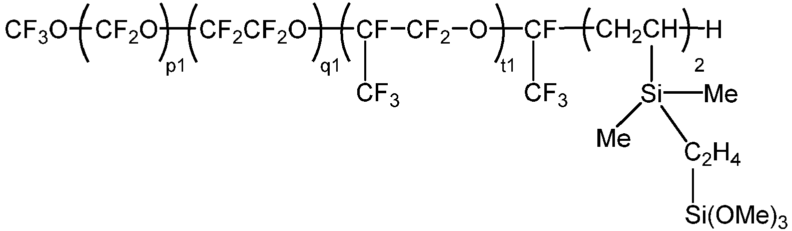 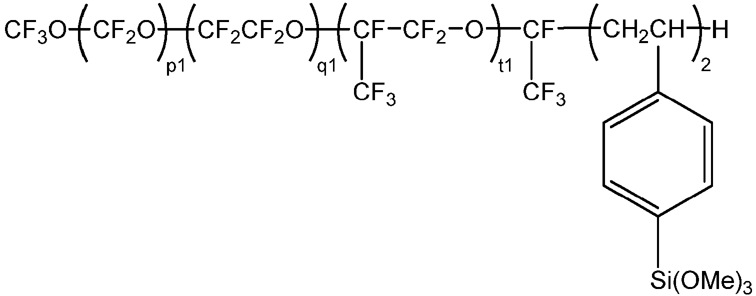 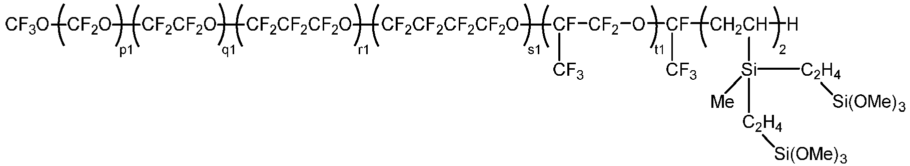 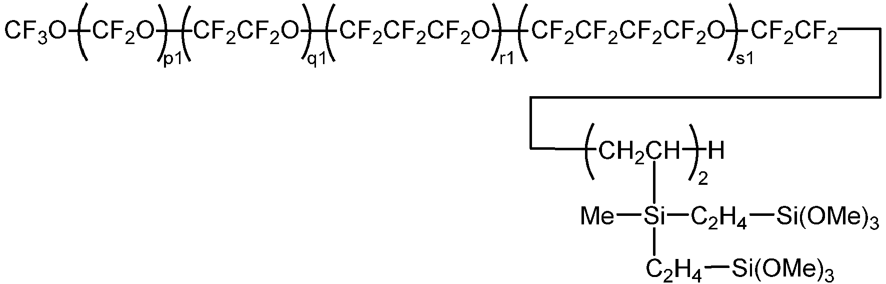 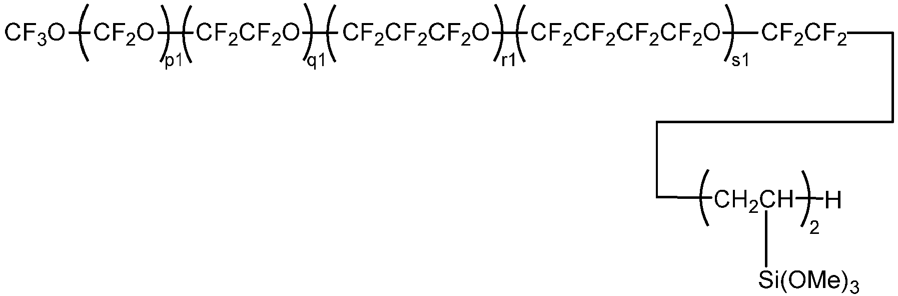 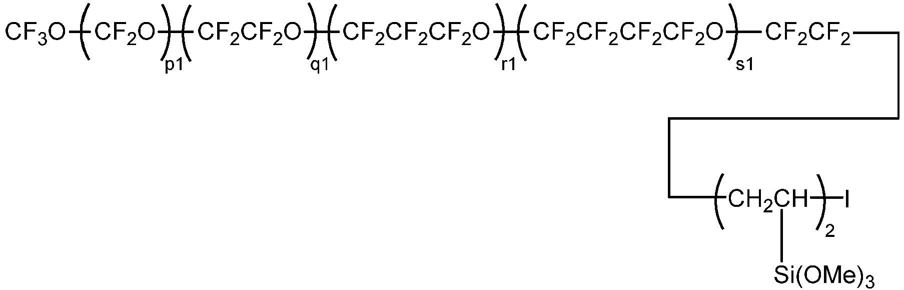 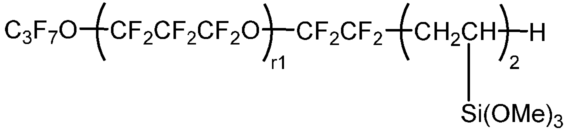 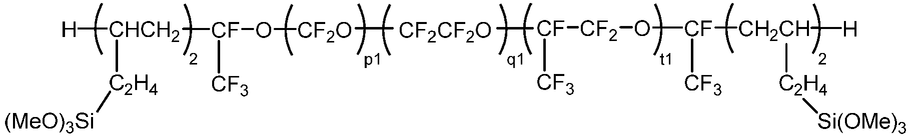 Herein Me is methyl, p1, q1, r1, s1, and t1 are each independently an integer of 1 to 200, the sum of p1, q1, r1, s1, and t1 is 3 to 500, each repeating unit in parentheses may be randomly arranged.

The hydrolyzable fluorinated organosilicon compound (hydrolyzable fluorine-containing organosilicon compound) having any of formulae (1) to (5) may contain such compounds in which some or all of the hydrolyzable groups (X) are hydrolyzed, that is, X is OH group and may further contain such compounds in which some or all of the OH groups are condensed.

Desirably the hydrolyzable fluorinated compound is previously diluted with a solvent. The solvent used herein is not particularly limited as long as the hydrolyzable fluorinated compound is uniformly dissolved. Examples include fluorine-modified aliphatic hydrocarbon solvents (e.g., perfluoroheptane and perfluorooctane), fluorine-modified aromatic hydrocarbon solvents (e.g., 1,3-trifluoromethylbenzene), fluorine-modified unsaturated hydrocarbon solvents (e.g., hexafluoroolefins and hexafluoropropene trimer), fluorine-modified ether solvents (e.g., methyl perfluorobutyl ether, ethyl perfluorobutyl ether, perfluoro(2-butyltetrahydrofuran)), fluorine-modified alkylamine solvents (e.g., perfluorotributylamine, perfluorotripentylamine), hydrocarbon solvents (e.g., petroleum benzine, toluene, xylene), and ketone solvents (e.g., acetone, methyl ethyl ketone, methyl isobutyl ketone). Of these, fluorine-modified solvents are desirable for solubility and stability, and fluorine-modified ether solvents and fluorine-modified aromatic hydrocarbon solvents are especially preferred.

The foregoing solvents may be used alone or in admixture.

The solvent is preferably used in such amounts that the concentration of the hydrolyzable fluorinated compound may fall in a range of 0.01 to 50% by weight, more preferably 0.03 to 10% by weight, even more preferably 0.05 to 1% by weight of the water/oil repellent agent (solution of the hydrolyzable fluorinated compound in the solvent).

The water/oil repellent agent containing the hydrolyzable fluorinated compound may be applied to substrates by any well-known processes such as wet coating processes (e.g., dipping, brush coating, spin coating, spraying, gravure coating, die coating, bar coating, and slit coating) and evaporation. Although coating and other conditions may accord with the prior art well-known process, it is efficient that the water/oil repellent agent containing the hydrolyzable fluorinated compound is deposited by the wet coating process because the primer layer is deposited by the wet coating process.

The hydrolyzable fluorinated compound may be cured at room temperature (25°C) for 1 to 24 hours. Cure may be completed within a shorter time by heating at 30 to 200°C for 1 minute to 1 hour. Cure under humid conditions (RH 50 to 90%) is preferred for accelerating hydrolysis.

It is noted that the surface of the primer layer on the substrate may be cleaned or activated by plasma treatment, UV treatment or ozone treatment before the water/oil repellent agent containing the hydrolyzable fluorinated compound is coated thereon.

The fluorinated layer (water/oil repellent layer) of the inventive water/oil repellent member has a thickness of 0.5 to 50 nm, preferably 1 to 20 nm. If the layer is too thick, the water/oil repellent layer on its outer surface may have a high surface resistivity. If the layer is too thin, surface properties and abrasion resistance may be insufficient.

The water/oil repellent layer of the inventive water/oil repellent member at its outer surface has a surface resistivity which is lower by at least 10 Ω/□ than in the absence of the second layer. If the surface resistivity of the water/oil repellent layer at its outer surface is too high, the layer can cause electronic devices such as organic EL devices to malfunction and allows for deposition of dust and debris to reduce the surface visibility, detracting from optical properties and quality. Further, the surface becomes susceptible to staining. As used herein, the surface resistivity is measured by a commercially available resistivity meter, for example, Hiresta-UX MCP-HT800 by Mitsubishi Chemical Analytech Co., Ltd.

The water/oil repellent layer at its outer surface has a surface resistivity of up to 1.0×10¹¹ Ω/□, preferably 1.0×10⁷ to 1.0×10¹¹ Ω/□, more preferably 1.0×10⁸ to 9.8×10¹⁰ Ω/□. In order that the water/oil repellent layer at its outer surface have a surface resistivity in the range, it is preferred that the primer layer composed mainly of an organosilicon compound having a plurality of silanol groups in the molecule has a thickness of 10 to 500 nm and the water/oil repellent layer disposed on the outer surface of the primer layer and composed mainly of a cured product of a hydrolyzable fluorinated compound has a thickness of 0.5 to 50 nm.

Examples of the inventive water/oil repellent member thus obtained include optical articles, for example, housings of car navigation systems, PC tablets, smartphones, foldable smartphones, flexible smartphones, flexible devices, digital cameras, digital video cameras, PDAs, portable audio players, car audio players, and video game consoles; optical articles such as lenses (e.g., camera lenses, surveillance cameras, vehicle mount lenses, eyeglass lenses, sunglasses, AR lenses, and VR lenses), medical instruments (e.g., gastroscopes, surgical knives, blood pressure gauges, X-ray CT, and MRI), touch panel surfaces in such displays as liquid crystal displays, organic EL displays, and flexible devices, protective films, antireflective films, IR cutoff filters, compact disks, DVDs, and Blu-ray disks; windowpanes, headlamp covers and headlamp lenses of automobiles, trains and aircraft; building members such as tiles and exterior members; kitchen building members such as system kitchen wares, bathtubs, showerheads, faucets, and cooking range hoods; bodies and mirrors of waiting rooms, art works and transportation vehicles; and covers of radars such as extremely high frequency (EHF) sensors.

### EXAMPLES

Examples and Comparative Examples are shown below for further illustrating the invention. Notably, Me stands for methyl.

### [Examples 1 to 13 and Comparative Examples 1 to 9]

Test specimens of the water/oil repellent member comprising a substrate, functional film layer, primer layer and water/oil repellent layer were prepared as follows.

### [Substrate]

Clear hard coat-treated PET film (specimen substrate of hard coat film FHC-53EEM2 by Higashiyama Film Co., Ltd., thickness 188 µm, width 50 mm, length 100 mm, pencil hardness: H according to JIS K5400 @500 g).

### [Formation of functional film layer (first layer)]

A functional film layer was formed on the substrate by the following method.

### [Formation of Functional film layer 1]

Functional film layer 1 of 100 nm thick was formed on the outer surface of the substrate by sputtering of silicon dioxide.

### [Formation of Functional film layer 2]

Functional film layer 2 of 96 nm thick was formed on the outer surface of the substrate by dip coating the substrate with a treating liquid of perhydropolysilazane diluted with dibutyl ether in a concentration of 2.0 wt% as solids and curing at 80°C/80% RH for 24 hours. The dip coating included dipping the substrate in the treating liquid for 30 seconds and pulling up at 150 mm/min. The raw material of Functional film layer 2 or perhydropolysilazane reacts with airborne moisture (water) in the course of curing to form a silicon dioxide (SiO₂) layer via dehydrogenation while releasing ammonia.

### [Formation of Functional film layer 3]

Functional film layer 3 of 10 nm thick was formed on the outer surface of the substrate by sputtering of silicon dioxide.

### [Formation of Functional film layer 4]

Functional film layer 4 was formed as the outermost layer of an antireflective layer on the surface of the substrate by sputtering of silicon dioxide. The antireflective layer had a multilayer structure including Nb₂O₅ (12 nm), SiO₂ (34 nm), Nb₂O₅ (116 nm), and SiO₂ (76 nm) stacked from the substrate side.

### [Formation of primer layer (second layer)]

A primer layer was formed on the substrate or functional film layer by the following method.

### [Formation of Primer layer 1]

Primer layer 1 of 10 nm thick was formed on the outer surface of the substrate by dip coating the substrate with a treating liquid of the hydrolytic partial condensate of tetraethoxysilane (Mw 25,000, silanol content 0.015 mol/g) diluted with butanol in a concentration of 0.2 wt% as solids by means of a bar coater (Bar Coater No. 02 by Daiichi Rika Co., Ltd.) and drying the coating at 80°C for 1 minute to evaporate off the butanol.

### [Formation of Primer layer 2]

Primer layer 2 of 30 nm thick was formed on the outer surface of the substrate by dip coating the substrate with a treating liquid of the hydrolytic partial condensate of tetraethoxysilane (Mw 25,000, silanol content 0.015 mol/g) diluted with butanol in a concentration of 0.78 wt% as solids and drying the coating at room temperature (25°C) for 60 minutes to evaporate off the butanol. The dip coating step included dipping the substrate in the treating liquid for 60 seconds and pulling up at 150 mm/min.

### [Formation of Primer layer 3]

Primer layer 3 of 91 nm thick was formed on the outer surface of the substrate by dip coating the substrate with a treating liquid of the hydrolytic partial condensate of tetraethoxysilane (Mw 25,000, silanol content 0.015 mol/g) diluted with butanol in a concentration of 2.0 wt% as solids and drying the coating at room temperature (25°C) for 60 minutes to evaporate off the butanol. The dip coating step included dipping the substrate in the treating liquid for 60 seconds and pulling up at 150 mm/min.

### [Formation of Primer layer 4]

Primer layer 4 of 210 nm thick was formed on the outer surface of the substrate by dip coating the substrate with a treating liquid of the hydrolytic partial condensate of tetraethoxysilane (Mw 25,000, silanol content 0.015 mol/g) diluted with butanol in a concentration of 4.0 wt% as solids and drying the coating at room temperature (25°C) for 60 minutes to evaporate off the butanol. The dip coating step included dipping the substrate in the treating liquid for 60 seconds and pulling up at 150 mm/min.

### [Formation of Primer layer 5]

Primer layer 5 of 5 nm thick was formed on the outer surface of the substrate by coating the substrate with a treating liquid of the hydrolytic partial condensate of tetraethoxysilane (Mw 25,000, silanol content 0.015 mol/g) diluted with butanol in a concentration of 0.1 wt% as solids by means of a bar coater (Bar Coater No. 02 by Daiichi Rika Co., Ltd.) and drying the coating at 80°C for 1 minute to evaporate off the butanol.

### [Formation of water/oil repellent layer (third layer)]

Further, a water/oil repellent layer was formed and laid on the outer surface of the substrate or each of the substrates having functional film layers 1 to 4 (shown in Table 1) or Primer layers 1 to 5 (shown in Table 1) formed thereon, by the following method.

### [Formation of Water/oil repellent layer 1]

Compound 1 shown below was diluted with a fluorine-modified ether solvent (Novec 7200 by 3M, ethyl perfluorobutyl ether) in a concentration of 0.1 wt% as solids to form a treating liquid. Using a spray coater (NST-51 by T&K Co., Ltd.), the treating liquid was sprayed onto the primer layer on the substrate. The coating was heated at 80°C for 30 minutes to evaporate off the fluorine-modified ether solvent and at the same time, cure the solids in the treating liquid to form a cured film (or water/oil repellent layer), yielding a specimen. The water/oil repellent layer 1 had an average thickness of ~10 nm as computed from the F content detected by an X-ray fluorescence analyzer (ZSXmini2 by Rigaku Corp.). 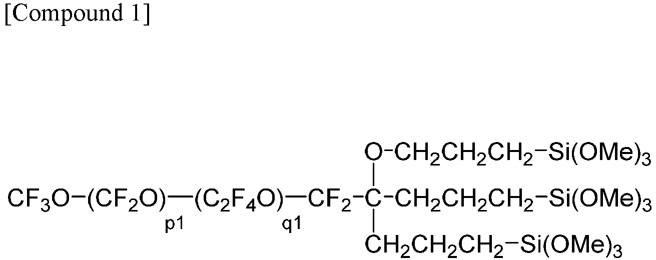 (p1+q1 = 48, pl:ql = 24:24)

### [Formation of Water/oil repellent layer 2]

Compound 2 shown below was diluted with a fluorine-modified ether solvent (Novec 7200 by 3M) in a concentration of 20 wt% as solids to form a treating liquid. Using a vacuum evaporation system (VTR-250 by Ulvac Inc.), the treating liquid was evaporated and deposited onto the primer layer on the substrate. It was allowed to stand at 25°C for 60 minutes to cure the solids as vacuum evaporated to form a cured film (water/oil repellent layer), yielding a specimen. The water/oil repellent layer 2 had an average thickness of ~11 nm as computed from the F content detected by an X-ray fluorescence analyzer (ZSXmini2 by Rigaku Corp.). 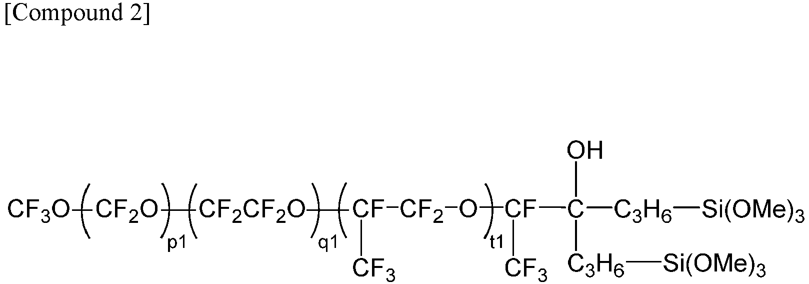 (p1+q1+t1 = 35, p1:q1:t1 = 17:16:2)

### [Formation of Water/oil repellent layer 3]

Compound 3 shown below was diluted with a fluorine-modified ether solvent (Novec 7200 by 3M) in a concentration of 0.2 wt% as solids to form a treating liquid. Using a bar coater (Bar Coater No. 02 by Daiichi Rika Co., Ltd.), the treating liquid was coated onto the primer layer on the substrate. It was allowed to stand at 25°C for 60 minutes for allowing the fluorine-modified ether solvent to evaporate off and at the same time, curing the solids in the treating liquid to form a cured film (water/oil repellent layer), yielding a specimen. The water/oil repellent layer 3 had an average thickness of ~15 nm as computed from the F content detected by an X-ray fluorescence analyzer (ZSXmini2 by Rigaku Corp.). 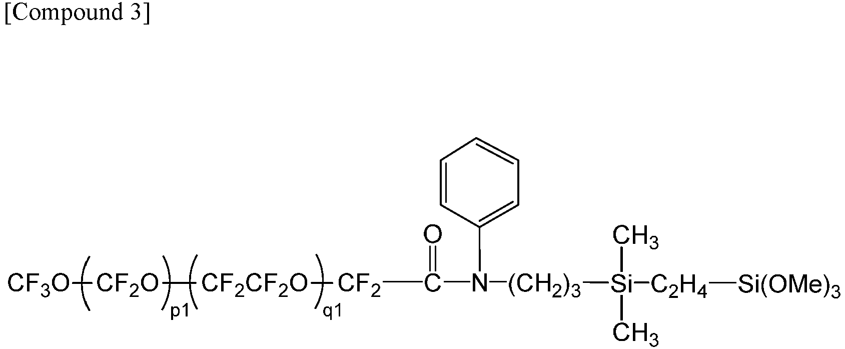 (p1+q1 = 60, p1:q1 = 29:31)

### [Formation of Water/oil repellent layer 4]

Compound 4 shown below was diluted with a fluorine-modified ether solvent (Novec 7200 by 3M) in a concentration of 0.1 wt% as solids to form a treating liquid. Using a spray coater (NST-51 by T&K Co., Ltd.), the treating liquid was sprayed onto the primer layer on the substrate. The coating was heated at 80°C for 30 minutes to evaporate off the fluorine-modified ether solvent and at the same time, cure the solids in the treating liquid to form a cured film (or water/oil repellent layer), yielding a specimen. The water/oil repellent layer 4 had an average thickness of ~13 nm as computed from the F content detected by an X-ray fluorescence analyzer (ZSXmini2 by Rigaku Corp.). 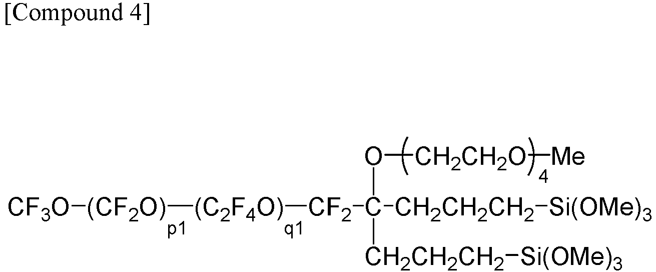 (p1+q1 = 42, pl:ql = 20:22)

### [Formation of Water/oil repellent layer 5]

Compound 5 shown below was diluted with a fluorine-modified ether solvent (Novec 7200 by 3M) in a concentration of 0.1 wt% as solids to form a treating liquid. Using a spray coater (NST-51 by T&K Co., Ltd.), the treating liquid was sprayed onto the primer layer on the substrate. The coating was heated at 80°C for 30 minutes to evaporate off the fluorine-modified ether solvent and at the same time, cure the solids in the treating liquid to form a cured film (or water/oil repellent layer), yielding a specimen. The water/oil repellent layer 5 had an average thickness of ~13 nm as computed from the F content detected by an X-ray fluorescence analyzer (ZSXmini2 by Rigaku Corp.). 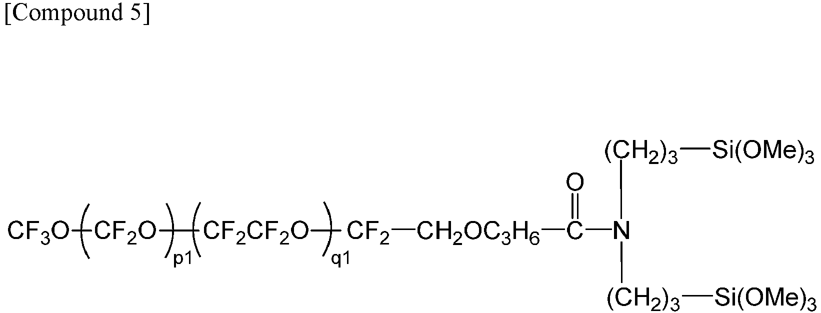 (p1+q1 = 50, pl:ql = 26:24)

### [Formation of Water/oil repellent layer 6]

Compound 6 shown below was diluted with a fluorine-modified ether solvent (Novec 7200 by 3M) in a concentration of 0.1 wt% as solids to form a treating liquid. Using a spray coater (NST-51 by T&K Co., Ltd.), the treating liquid was sprayed onto the primer layer on the substrate. The coating was heated at 80°C for 30 minutes to evaporate off the fluorine-modified ether solvent and at the same time, cure the solids in the treating liquid to form a cured film (or water/oil repellent layer), yielding a specimen. The water/oil repellent layer 6 had an average thickness of ~12 nm as computed from the F content detected by an X-ray fluorescence analyzer (ZSXmini2 by Rigaku Corp.). 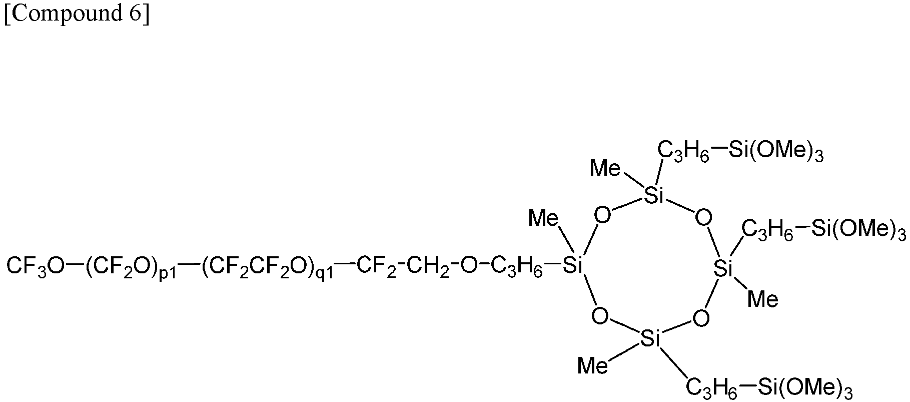 (p1+q1 = 38, pl:ql = 19:19)

On the specimens of water/oil repellent member having a functional film layer, a primer layer, and/or a water/oil repellent layer, the following measurements were carried out. The results are also shown in Table 1.

### [Antistatic property]

Using a resistivity meter Hiresta-UX MCP-HT800 (Mitsubishi Chemical Analytech Co., Ltd.), the surface resistivity was measured under the following conditions and reported as an index of antistatic property.
Applied voltage: 1,000 V

### [Water and oil repellency]

Using a contact angle meter (DropMaster by Kyowa Interface Science Co., Ltd.), the contact angles of the cured film (water/oil repellent layer) of the specimen with water and oleic acid were measured.

### [Eraser abrasion resistance]

Using a rubbing tester (Shinto Scientific Co., Ltd.), an abrasion resistance test was carried out on the cured film (water/oil repellent layer) of the specimen under the following conditions. The cured film (or water/oil repellent layer) after 100 back-and-forth rubbing cycles was measured for a contact angle with water (or water repellency) as above. The number of rubbing cycles within which the contact angle with water was kept above 100° was reported as an index of eraser abrasion resistance. The test environmental conditions included 25°C and humidity 50%.

| | |
|---|---|
| Eraser: | by Minoan Co., Ltd. |
| Contact area: | diameter 6 mm |
| Moving distance (one way): | 30 mm |
| Moving speed: | 3,600 mm/min |
| Load: | 500 g/diameter 6 mm |

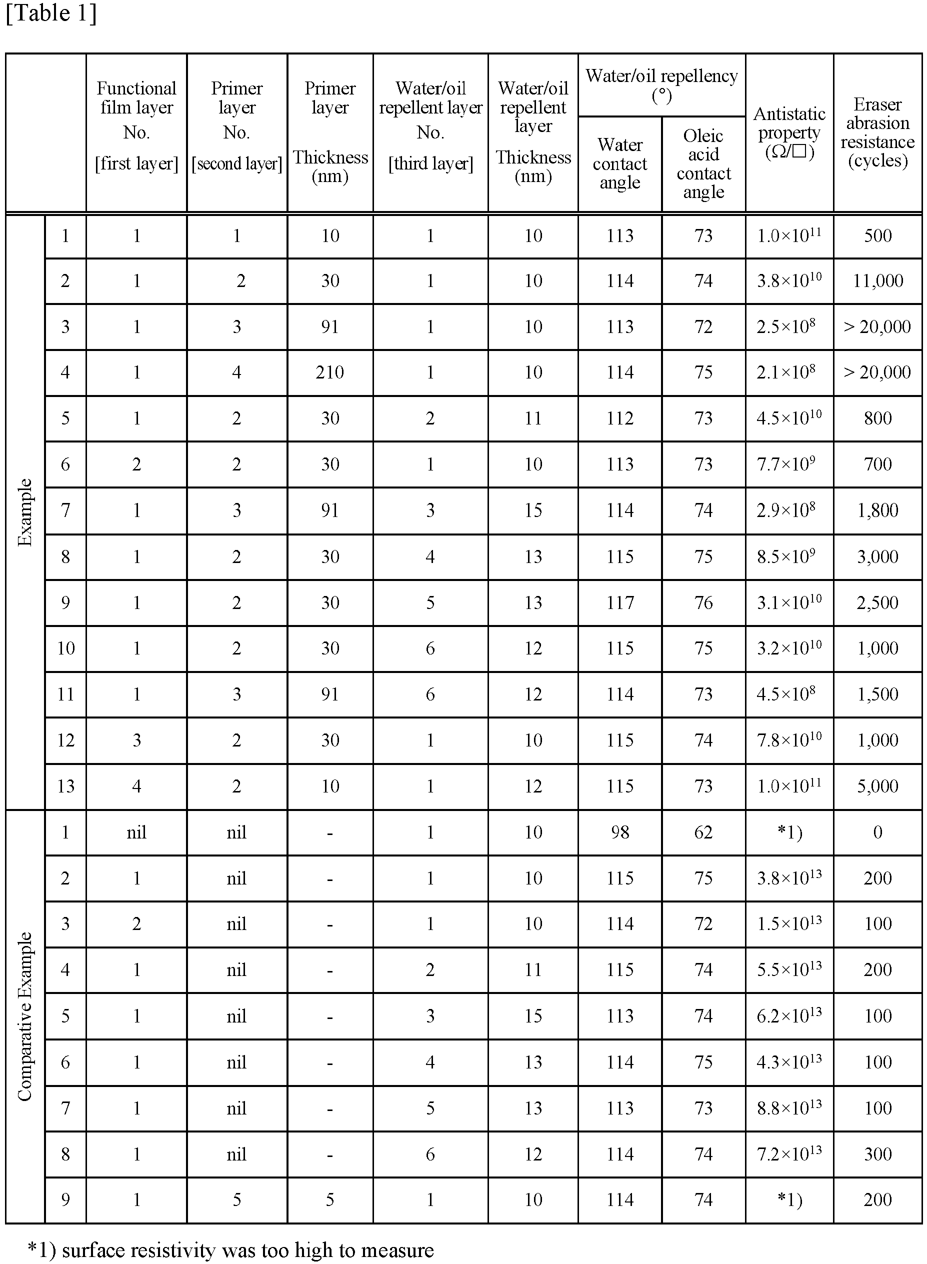

As is evident from the results in Table 1, Examples 1 to 13 exhibited excellent water/oil repellency and eraser abrasion resistance. By contrast, Comparative Examples 1 to 9 exhibited unsatisfactory abrasion resistance as demonstrated by the count of eraser abrasion resistance being less than 500 cycles. Comparative Example 1 exhibited inferior initial water/oil repellency because the water/oil repellent agent was coated directly on the hard coat layer. Comparative Example 2 exhibited insufficient abrasion resistance because the primer layer was omitted. Comparative Example 3 wherein a polysilazane layer was formed as the functional film layer exhibited insufficient abrasion resistance because the primer layer was omitted. Comparative Examples 4 to 8 wherein the water/oil repellent agent was changed exhibited insufficient abrasion resistance because the primer layer was omitted. Comparative Example 9 exhibited insufficient abrasion resistance because the primer layer was too thin.

In Examples 1 to 13, the water/oil repellent layer on its outer surface had a surface resistivity of up to 1.0×10¹¹ Ω/□ because the primer layer of at least 10 nm thick was formed.

## Claims

1. A water repellent and oil repellent member comprising:
a substrate,
a functional film layer disposed on at least one surface of the substrate as a first layer,
a primer layer disposed on the outer surface of the functional film layer as a second layer, and
a water repellent and oil repellent layer disposed on the outer surface of the primer layer as a third layer,
wherein the functional film layer is a silicon dioxide layer having a thickness of 10 to 500 nm or has a multilayer structure which includes at least an outermost layer composed of silicon dioxide and having a thickness of 10 to 500 nm,
wherein the primer layer is a layer composed mainly of an organopolysiloxane compound having a plurality of silanol groups in the molecule and having a thickness of 10 to 500 nm, the organopolysiloxane compound having a plurality of silanol groups in the molecule being a hydrolytic partial condensate of a tetraalkoxysilane and having a silanol content of 0.002 to 0.042 mol/g, and
wherein the water repellent and oil repellent layer is a layer composed mainly of a cured product of a hydrolyzable fluorinated compound and having a thickness of 0.5 to 50 nm.

2. The water repellent and oil repellent member of claim 1, wherein the functional film layer is any one of a hard coat layer composed of a silicon dioxide layer, a hard coat layer of two, three or multilayer structure including a hard coat layer and a silicon dioxide layer formed thereon, an antireflective layer of two, three or multilayer structure having an outermost layer of silicon dioxide formed on a substrate, and an IR cutoff filter layer of two, three or multilayer structure having an outermost layer of silicon dioxide formed on a substrate.

3. The water repellent and oil repellent member of claim 1 or 2, wherein the organopolysiloxane compound has a weight average molecular weight of 300 to 100,000, as measured in accordance with the method disclosed in the description.

4. The water repellent and oil repellent member of any one of claims 1 to 3, wherein the hydrolysable fluorinated compound has at least one hydrolysable silyl group at one or more ends of the molecular chain, the hydrolysable silyl group being selected from among C₁₋₁₂ alkoxy groups, C₂₋₁₂ alkoxyalkoxy groups, C₁₋₁₀ acyloxy groups, C₂₋₁₀ alkenyloxy groups, halogen or amino-containing silyl groups, and silazane groups.

5. The water repellent and oil repellent member of any one of claims 1 to 4, wherein the hydrolysable fluorinated compound is a fluorooxyalkylene group-containing organosilicon compound having, in its molecule, a divalent linear perfluorooxyalkylene polymer residue of the formula: -(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-wherein p, q, r, s, and t are each independently an integer of 0 to 200, p+q+r+s+t is 3 to 500, each repeat unit in parentheses may be randomly arranged, d is independently an integer of 0 to 8, the unit with d may be linear or branched, and having at least one hydrolysable silyl group at one or more ends of the molecular chain.

6. The water repellent and oil repellent member of any one of claims 1 to 5, wherein the hydrolyzable fluorinated compound is at least one compound selected from hydrolysable fluorinated organosilicon compounds having the general formulae (1) to (5):
(A-Rf)_{α}-ZW_{β} (1)
Rf-(ZW_{β})₂ (2)
Z'-(Rf-ZW_{β})_{γ} (3)
wherein Rf is a divalent linear perfluorooxyalkylene polymer residue of the formula: -(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-, p, q, r, s, and t are each independently an integer of 0 to 200, p+q+r+s+t is 3 to 500, each repeat unit in parentheses may be randomly arranged, d is independently an integer of 0 to 8, the unit with d may be linear or branched, A is fluorine, hydrogen or a monovalent fluorinated group terminated with -CF₃, -CF₂H or -CH₂F group, Z and Z' are each independently a single bond, or a di- to octavalent organic group which may contain nitrogen, oxygen, silicon, phosphorus or sulfur and which may be fluorinated, W is a monovalent organic group terminated with a hydrolyzable group, α and β are each independently an integer of 1 to 7, α+β is 2 to 8, and γ is an integer of 2 to 8,
A-Rf-Q-(Y)_{δ}-B (4)
Rf-(Q-(Y)_{δ}-B)₂ (5)
wherein Rf and A are as defined above, Q is a single bond or divalent organic group, δ is each independently an integer of 1 to 10, Y is a divalent organic group having a hydrolyzable group, and B is hydrogen, C₁₋₄ alkyl or halogen.

7. The water repellent and oil repellent member of claim 6, wherein the hydrolyzable fluorinated organosilicon compound is selected from the following: 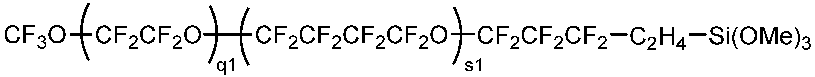 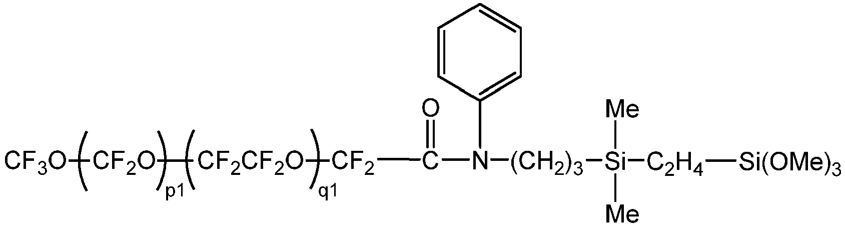 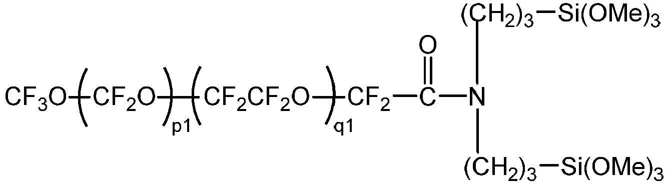 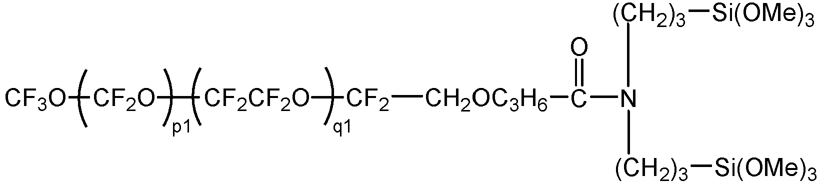 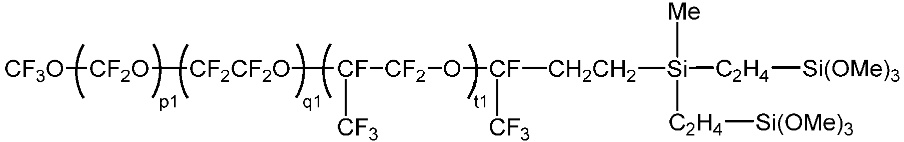 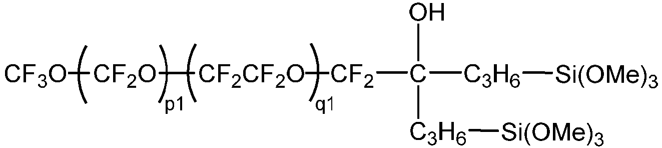 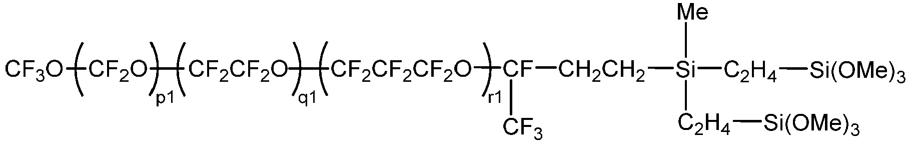 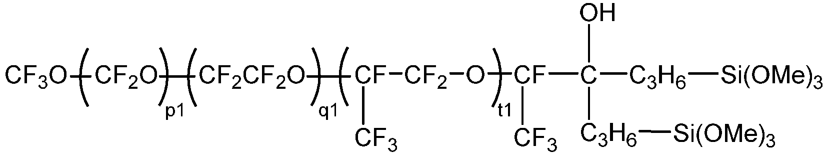 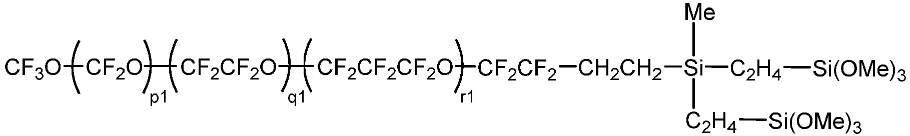 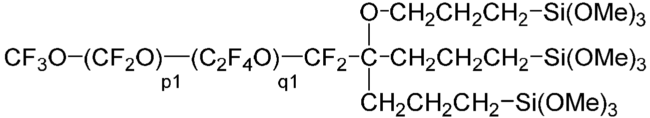 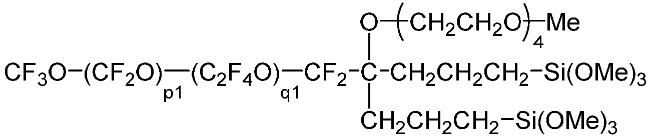 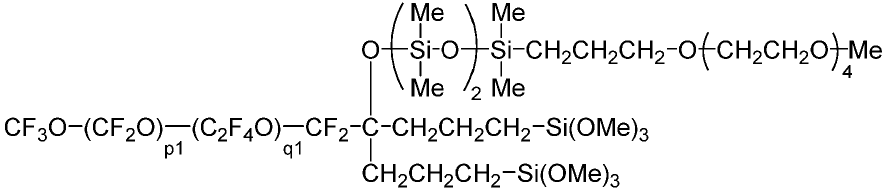 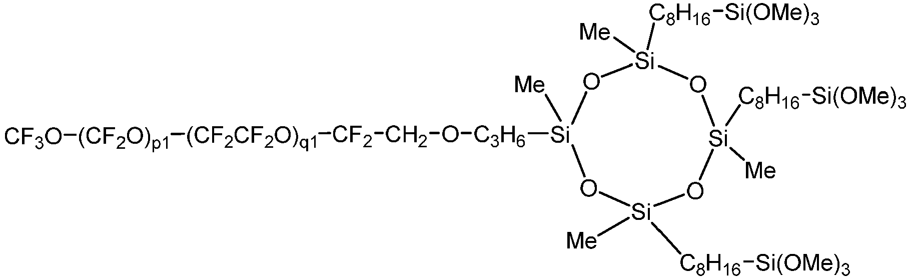 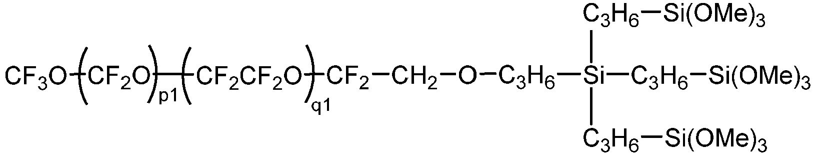 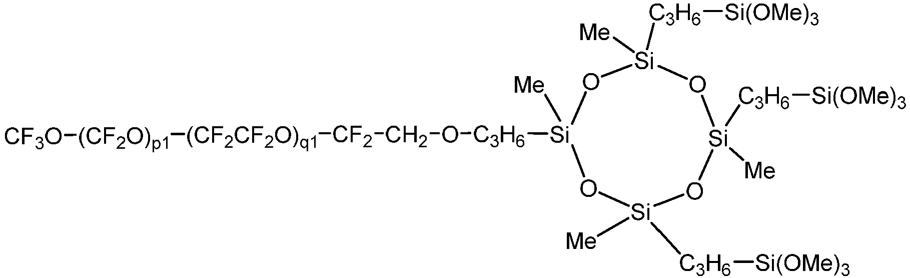 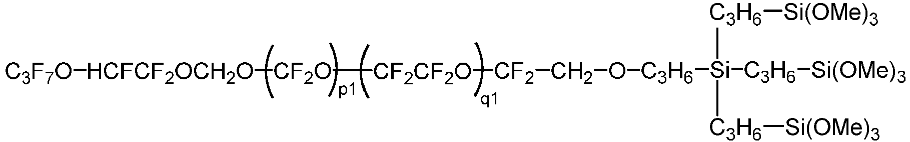 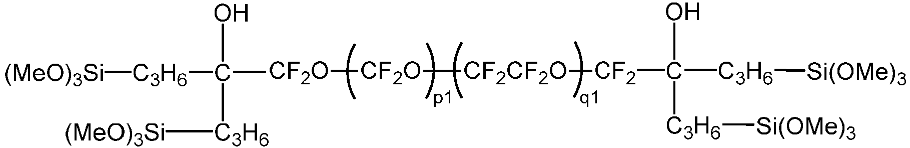 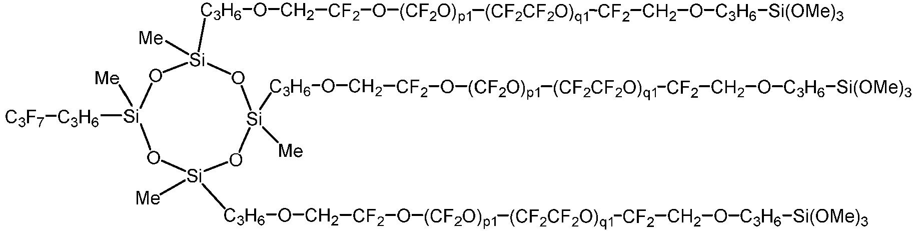 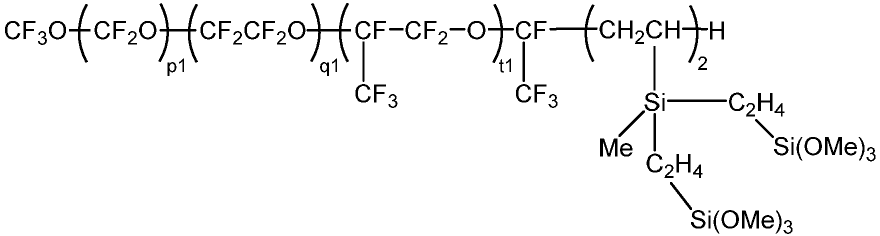 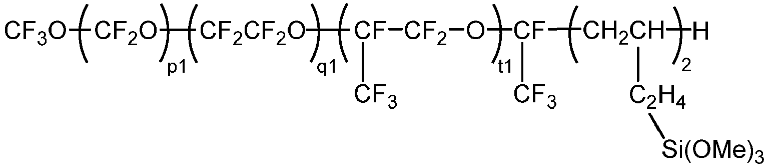 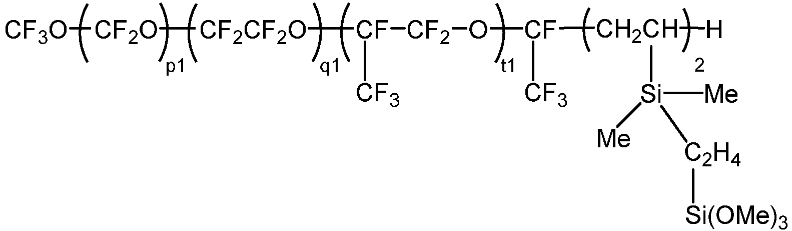 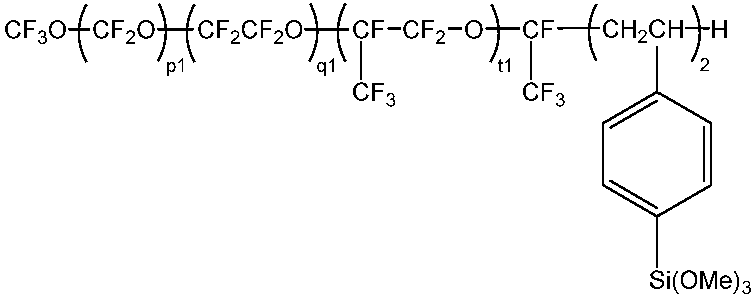 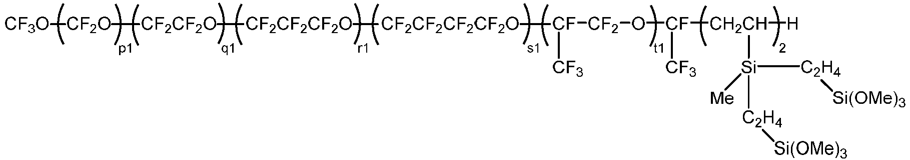 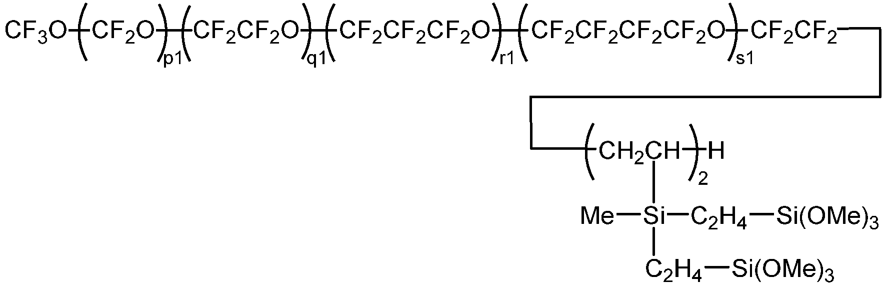 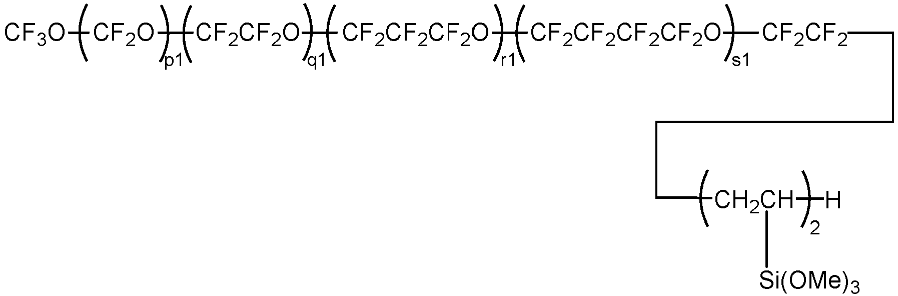 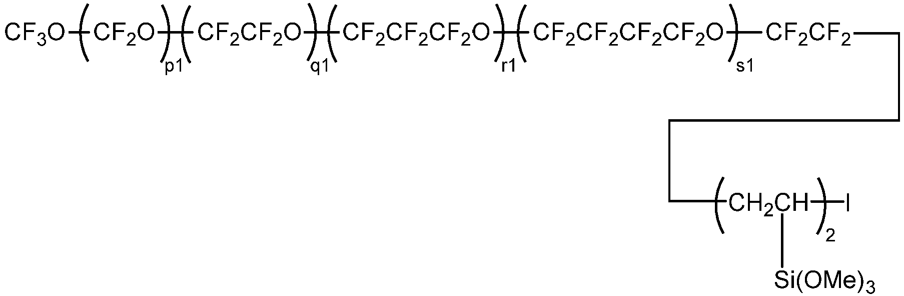 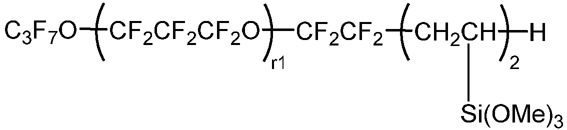 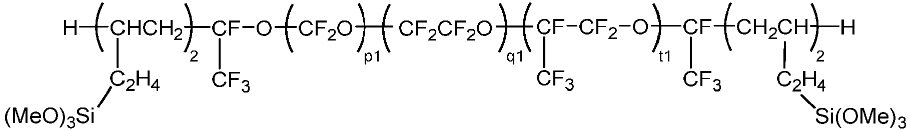 wherein Me is methyl, p1, q1, r1, s1, and t1 are each independently an integer of 1 to 200, the sum of p1, q1, r1, s1, and t1 is 3 to 500, each repeat unit in parentheses may be randomly arranged.

8. The water repellent and oil repellent member of any one of claims 1 to 7, wherein the substrate is of a resin, ceramic, metal, quartz, glass, sapphire, or diamond.

9. A method for preparing the water repellent and oil repellent member of any one of claims 1 to 8, the method comprising the steps of:
forming a functional film layer on at least one surface of a substrate, the functional film layer being a silicon dioxide layer having a thickness of 10 to 500 nm or having a multilayer structure which includes at least an outermost layer composed of silicon dioxide and having a thickness of 10 to 500 nm,
wet coating a solution of an organopolysiloxane compound having a plurality of silanol groups in the molecule in a solvent onto the outer surface of the functional film layer, and then evaporating the solvent to form and lay a primer layer having a thickness of 10 to 500 nm on at least one surface of the substrate, the organopolysiloxane compound having a plurality of silanol groups in the molecule being a hydrolytic partial condensate of a tetraalkoxysilane and having a silanol content of 0.002 to 0.042 mol/g, and
wet coating a solution of a hydrolyzable fluorinated compound in a solvent onto the outer surface of the primer layer and then evaporating the solvent, or evaporating off the solvent from the solution and dry coating the hydrolyzable fluorinated compound onto the outer surface of the primer layer, and curing the hydrolyzable fluorinated compound to form and lay a water repellent and oil repellent layer on the outer surface of the primer layer.

## Patentansprüche

1. Wasserabweisendes und ölabweisendes Element, umfassend:
ein Substrat,
eine funktionelle Filmschicht, die auf mindestens einer Oberfläche des Substrats als erste Schicht angeordnet ist,
eine Grundierungsschicht, die auf der Außenfläche der funktionellen Filmschicht als zweite Schicht angeordnet ist, und
eine wasserabweisende und ölabweisende Schicht, die auf der Außenfläche der Grundierungsschicht als dritte Schicht angeordnet ist,
wobei die funktionelle Filmschicht eine Siliciumdioxidschicht mit einer Dicke von 10 bis 500 nm ist oder eine Mehrschichtstruktur aufweist, die mindestens eine äußerste Schicht umfasst, die aus Siliciumdioxid besteht und eine Dicke von 10 bis 500 nm aufweist,
wobei die Grundierungsschicht eine Schicht ist, die hauptsächlich aus einer Organopolysiloxanverbindung mit einer Vielzahl von Silanolgruppen im Molekül besteht und eine Dicke von 10 bis 500 nm aufweist, wobei die Organopolysiloxanverbindung mit einer Vielzahl von Silanolgruppen im Molekül ein hydrolytisches Teilkondensat eines Tetraalkoxysilans ist und einen Silanolgehalt von 0,002 bis 0,042 mol/g aufweist, und
wobei die wasserabweisende und ölabweisende Schicht eine Schicht ist, die hauptsächlich aus einem ausgehärteten Produkt einer hydrolysierbaren fluorierten Verbindung besteht und eine Dicke von 0,5 bis 50 nm aufweist.

2. Wasserabweisendes und ölabweisendes Element nach Anspruch 1, wobei die funktionelle Filmschicht eine ist aus: einer Hartbeschichtungsschicht, die aus einer Siliciumdioxidschicht besteht; einer Hartbeschichtungsschicht mit einer Zwei-, Drei- oder Mehrschichtstruktur, die eine Hartbeschichtungsschicht und eine darauf ausgebildete Siliciumdioxidschicht umfasst; einer Antireflexionsschicht mit einer Zwei-, Drei- oder Mehrschichtstruktur mit einer äußersten Schicht aus Siliciumdioxid, die auf einem Substrat ausgebildet ist, sowie einer IR-Sperrfilterschicht mit einer Zwei-, Drei- oder Mehrschichtstruktur mit einer äußersten Schicht aus Siliciumdioxid, die auf einem Substrat ausgebildet ist.

3. Wasserabweisendes und ölabweisendes Element nach Anspruch 1 oder 2, wobei die Organopolysiloxanverbindung ein gewichtsmittleres Molekulargewicht von 300 bis 100.000 aufweist, gemessen gemäß dem in der Beschreibung offenbarten Verfahren.

4. Wasserabweisendes und ölabweisendes Element nach einem der Ansprüche 1 bis 3, wobei die hydrolysierbare fluorierte Verbindung mindestens eine hydrolysierbare Silylgruppe an einem oder mehreren Enden der Molekülkette aufweist, wobei die hydrolysierbare Silylgruppe ausgewählt ist aus C₁₋₁₂-Alkoxygruppen, C₂₋₁₂-Alkoxyalkoxygruppen, C₁₋₁₀-Acyloxygruppen, C₂₋₁₀-Alkenyloxygruppen, halogen- oder aminohaltigen Silylgruppen und Silazangruppen.

5. Wasserabweisendes und ölabweisendes Element nach einem der Ansprüche 1 bis 4, wobei die hydrolysierbare fluorierte Verbindung eine fluoroxyalkylengruppenhaltige Organosiliciumverbindung ist, die in ihrem Molekül einen zweiwertigen linearen Perfluoroxyalkylen-Polymerrest der Formel:
-(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-
aufweist, wobei p, q, r, s und t jeweils unabhängig voneinander eine ganze Zahl von 0 bis 200 sind, p + q + r + s + t 3 bis 500 beträgt, jede in Klammern stehende Wiederholungseinheit zufällig angeordnet sein kann, d unabhängig eine ganze Zahl von 0 bis 8 ist, die Einheit mit d linear oder verzweigt sein kann und mindestens eine hydrolysierbare Silylgruppe an einem oder mehreren Enden der Molekülkette aufweist.

6. Wasserabweisendes und ölabweisendes Element nach einem der Ansprüche 1 bis 5, wobei die hydrolysierbare fluorierte Verbindung mindestens eine Verbindung ist, ausgewählt aus hydrolysierbaren fluorierten Organosiliciumverbindungen mit den allgemeinen Formeln (1) bis (5):
(A-Rf)_{α}-ZW_{β} (1)
Rf-(ZW_{β})₂ (2)
Z'-(Rf-ZW_{β})_{γ} (3)
wobei Rf ein zweiwertiger linearer Perfluoroxyalkylen-Polymerrest der Formel: -(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-ist, p, q, r, s und t jeweils unabhängig voneinander eine ganze Zahl von 0 bis 200 sind, p + q + r + s + t 3 bis 500 beträgt, jede in Klammern stehende Wiederholungseinheit zufällig angeordnet sein kann, d unabhängig eine ganze Zahl von 0 bis 8 ist, die Einheit mit d linear oder verzweigt sein kann, A Fluor, Wasserstoff oder eine einwertige fluorierte Gruppe ist, die mit einer -CF₃-, -CF₂H- oder -CH₂F-Gruppe endet, Z und Z' jeweils unabhängig voneinander eine Einfachbindung oder eine zwei- bis achtwertige organische Gruppe sind, die Stickstoff, Sauerstoff, Silicium, Phosphor oder Schwefel enthalten kann und die fluoriert sein kann, W eine einwertige organische Gruppe ist, die mit einer hydrolysierbaren Gruppe endet, α und β jeweils unabhängig voneinander eine ganze Zahl von 1 bis 7 sind, α + β 2 bis 8 beträgt und γ eine ganze Zahl von 2 bis 8 ist,
A-Rf-Q-(Y)_{δ}-B (4)
Rf-(Q-(Y)_{δ}-B)₂ (5)
wobei Rf und A wie oben definiert sind, Q eine Einfachbindung oder eine zweiwertige organische Gruppe ist, δ jeweils unabhängig voneinander eine ganze Zahl von 1 bis 10 ist, Y eine zweiwertige organische Gruppe mit einer hydrolysierbaren Gruppe ist und B Wasserstoff, C₁₋₄-Alkyl oder Halogen ist.

7. Wasserabweisendes und ölabweisendes Element nach Anspruch 6, wobei die hydrolysierbare fluorierte Organosiliciumverbindung aus den folgenden ausgewählt ist: 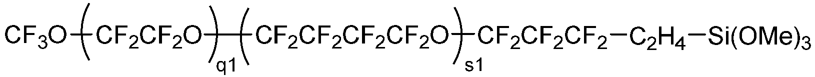 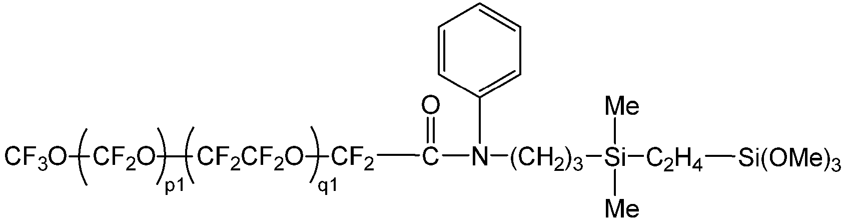 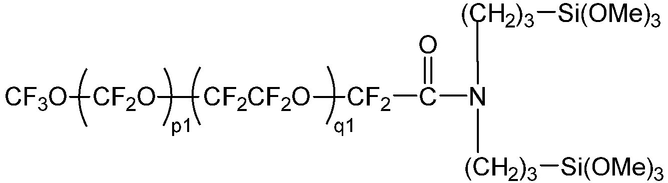 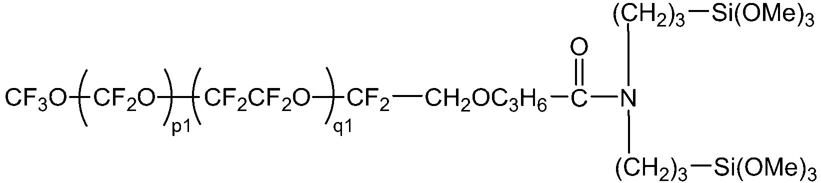 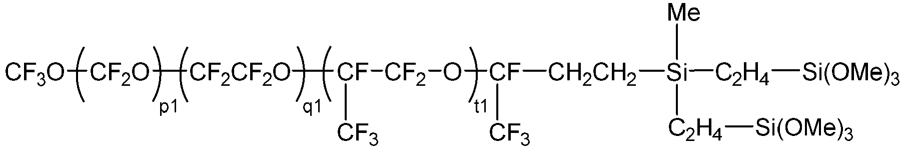 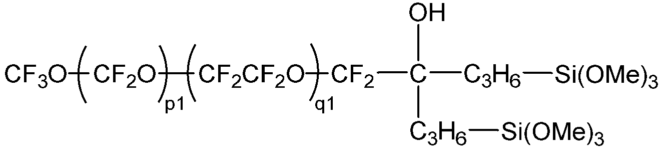 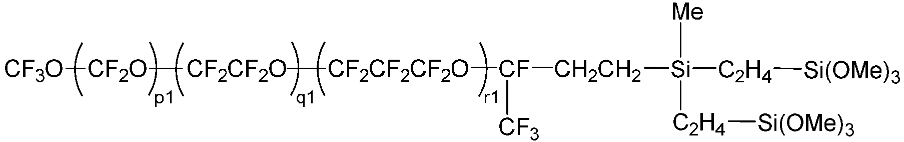 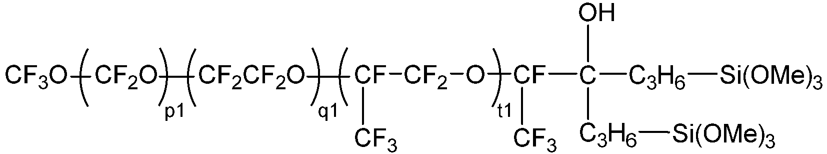 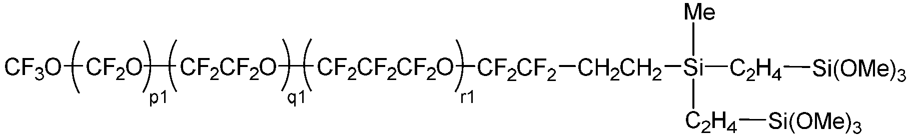 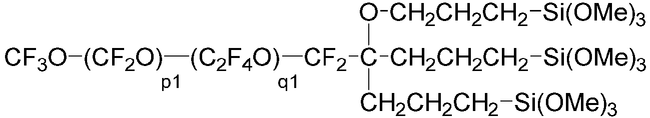 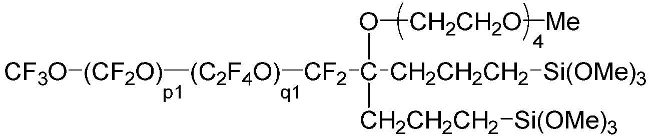 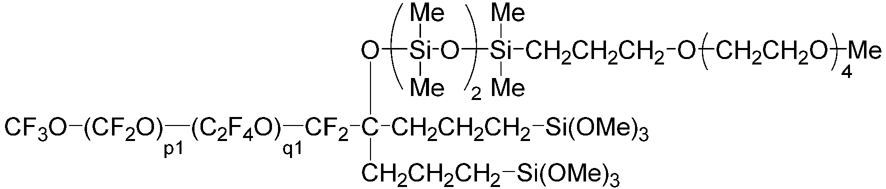 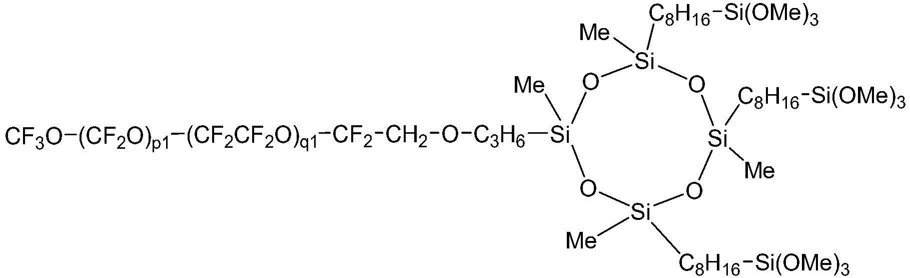 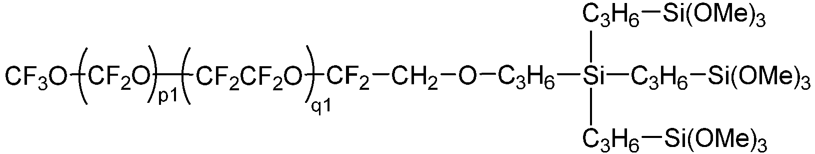 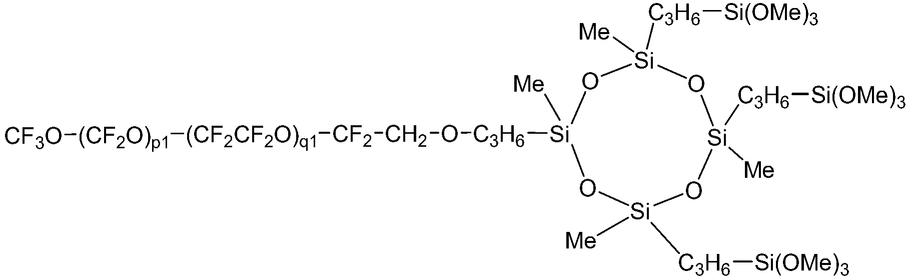 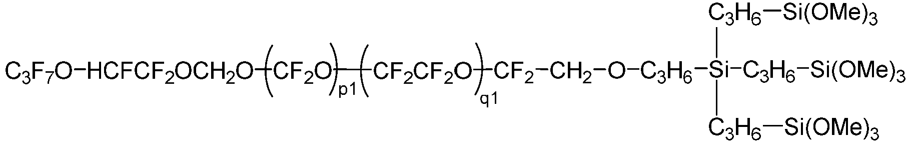 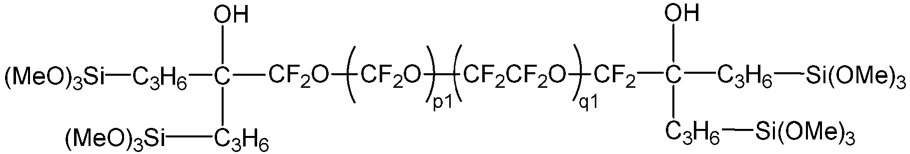 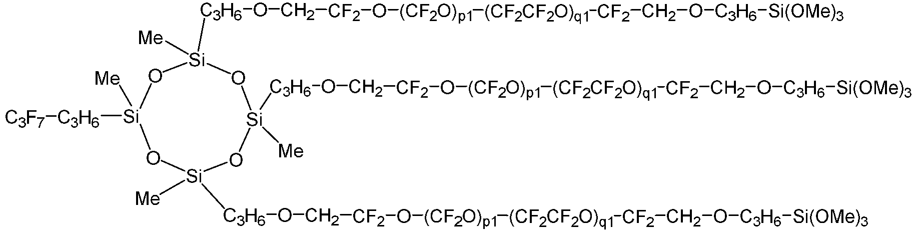 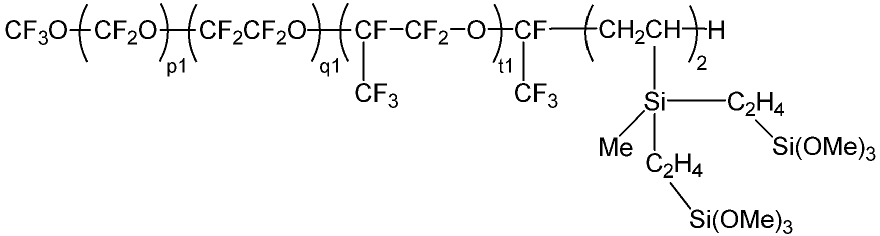 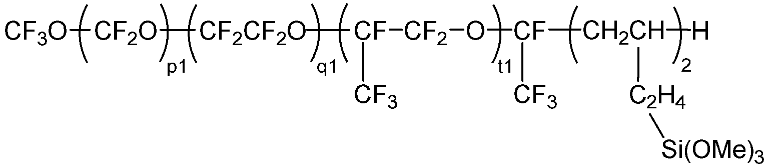 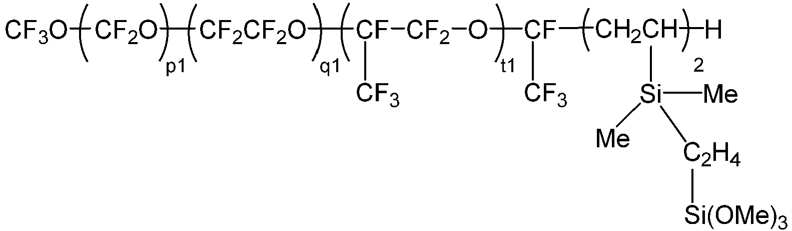 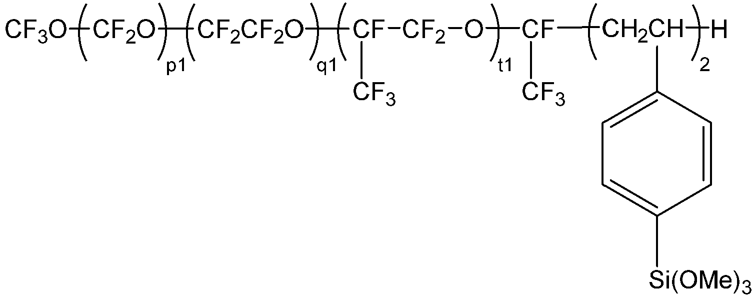 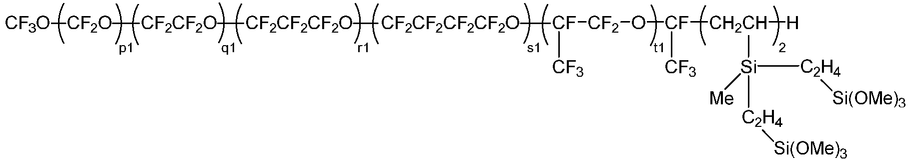 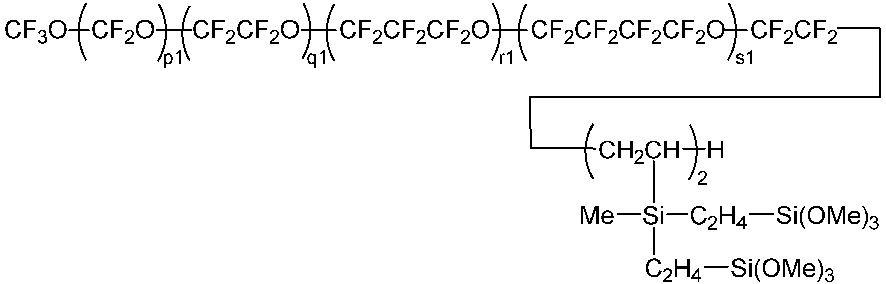 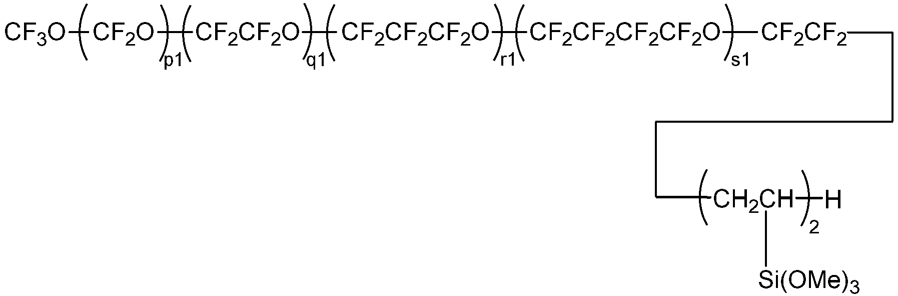 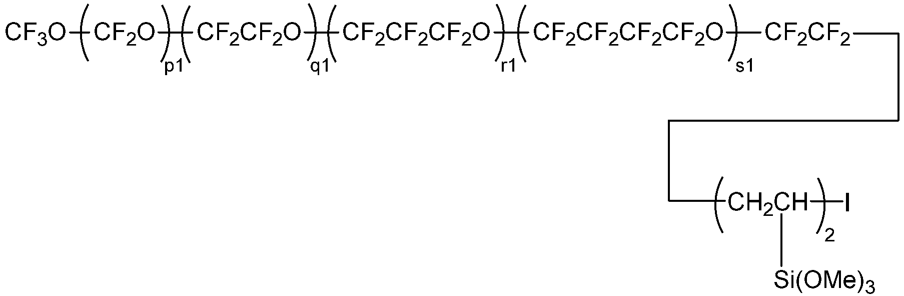 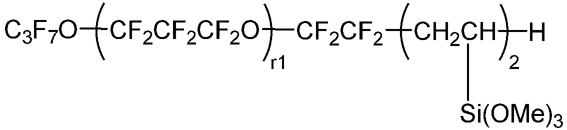 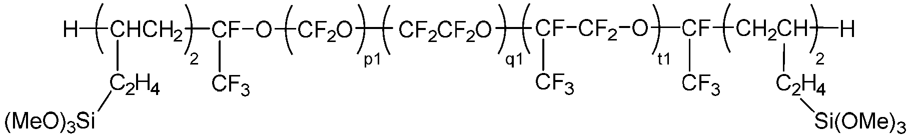 wobei Me für Methyl steht, p1, q1, r1, s1 und t1 jeweils unabhängig voneinander eine ganze Zahl von 1 bis 200 sind, die Summe aus p1, q1, r1, s1 und t1 3 bis 500 beträgt und jede in Klammern stehende Wiederholungseinheit zufällig angeordnet sein kann.

8. Wasserabweisendes und ölabweisendes Element nach einem der Ansprüche 1 bis 7, wobei das Substrat aus einem Harz, Keramik, Metall, Quarz, Glas, Saphir oder Diamant besteht.

9. Verfahren zur Herstellung des wasserabweisenden und ölabweisenden Elements nach einem der Ansprüche 1 bis 8, wobei das Verfahren die Schritte umfasst:
Bilden einer funktionellen Filmschicht auf mindestens einer Oberfläche eines Substrats, wobei die funktionelle Filmschicht eine Siliciumdioxidschicht mit einer Dicke von 10 bis 500 nm ist oder eine Mehrschichtstruktur aufweist, die mindestens eine äußerste Schicht umfasst, die aus Siliciumdioxid besteht und eine Dicke von 10 bis 500 nm aufweist,
Nassbeschichten einer Lösung einer Organopolysiloxanverbindung, die eine Vielzahl von Silanolgruppen im Molekül aufweist, in einem Lösungsmittel auf die Außenfläche der funktionellen Filmschicht und anschließendes Verdampfen des Lösungsmittels, um eine Grundierungsschicht mit einer Dicke von 10 bis 500 nm auf mindestens einer Oberfläche des Substrats zu bilden und aufzubringen, wobei die Organopolysiloxanverbindung mit einer Vielzahl von Silanolgruppen im Molekül ein hydrolytisches Teilkondensat eines Tetraalkoxysilans ist und einen Silanolgehalt von 0,002 bis 0,042 mol/g aufweist, und
Nassbeschichten einer Lösung einer hydrolysierbaren fluorierten Verbindung in einem Lösungsmittel auf die Außenfläche der Grundierungsschicht und anschließendes Verdampfen des Lösungsmittels oder das Verdampfen des Lösungsmittels aus der Lösung und Trockenbeschichten der hydrolysierbaren fluorierten Verbindung auf die Außenfläche der Grundierungsschicht, und Aushärten der hydrolysierbaren fluorierten Verbindung, um eine wasserabweisende und ölabweisende Schicht auf der Außenfläche der Grundierungsschicht zu bilden und aufzubringen.

## Revendications

1. Élément hydrofuge et oléofuge comportant :
un substrat,
une couche de film fonctionnel disposée sur au moins une surface du substrat en tant que première couche,
une couche d'apprêt disposée sur la surface extérieure de la couche de film fonctionnel en tant que deuxième couche, et
une couche hydrofuge et oléofuge disposée sur la surface extérieure de la couche d'apprêt en tant que troisième couche,
dans lequel la couche de film fonctionnel est une couche de dioxyde de silicium ayant une épaisseur de 10 à 500 nm ou a une structure multicouche qui inclut au moins une couche la plus à l'extérieur composée de dioxyde de silicium et ayant une épaisseur de 10 à 500 nm,
dans lequel la couche d'apprêt est une couche principalement composée d'un composé d'organopolysiloxane possédant une pluralité de groupes silanol dans la molécule et ayant une épaisseur de 10 à 500 nm, le composé d'organopolysiloxane possédant une pluralité de groupes silanol dans la molécule étant un condensat partiel hydrolytique d'un tétraalcoxysilane et ayant une teneur en silanol de 0,002 à 0,042 mol/g, et
dans lequel la couche hydrofuge et oléofuge est une couche principalement composée d'un produit durci d'un composé fluoré hydrolysable et ayant une épaisseur de 0,5 à 50 nm.

2. Élément hydrofuge et oléofuge selon la revendication 1, dans lequel la couche de film fonctionnel est un élément quelconque parmi une couche de revêtement dure composée d'une couche de dioxyde de silicium, d'une couche de revêtement dure ayant une structure à deux, trois ou plus de trois couches incluant une couche de revêtement dure et une couche de dioxyde de silicium formée sur celle-ci, d'une couche antiréfléchissante ayant une structure à deux, trois ou plus de trois couches ayant une couche la plus à l'extérieur de dioxyde de silicium formée sur un substrat, et une couche de filtre de coupure IR ayant une structure à deux, trois ou plus de trois couches, ayant une couche la plus à l'extérieur de dioxyde de silicium formée sur un substrat.

3. Élément hydrofuge et oléofuge selon la revendication 1 ou 2, dans lequel le composé d'organopolysiloxane a une masse moléculaire moyenne en masse de 300 à 100 000, lorsqu'elle est mesurée conformément au procédé décrit dans la description.

4. Élément hydrofuge et oléofuge selon l'une quelconque des revendications 1 à 3, dans lequel le composé fluoré hydrolysable possède au moins un groupe silyle hydrolysable à une ou plusieurs extrémités de la chaîne moléculaire, le groupe silyle hydrolysable étant choisi parmi des groupes alcoxy en C₁ à C₁₂, des groupes alcoxyalcoxy en C₂ à C₁₂, des groupes acyloxy en C₁ à C₁₀, des groupes alcényloxy en C₂ à C₁₀, des groupes silyle contenant un halogène ou un amino, et des groupes silazane.

5. Élément hydrofuge et oléofuge selon l'une quelconque des revendications 1 à 4, dans lequel le composé fluoré hydrolysable est un composé organosilicié contenant un groupe fluorooxyalkylène ayant, dans sa molécule, un résidu de polymère perfluorooxyalkylène linéaire divalent de formule : -(CF₂)_{d}-O-(CF₂O)ₚ(CF₂CF₂O)_{q}(CF₂CF₂CF₂O)ᵣ(CF₂CF₂CF₂CF₂O)ₛ(CF(CF₃)CF₂O)ₜ-(CF₂)_{d}-, dans laquelle p, q, r, s et t sont chacun, indépendamment les uns des autres, un entier de 0 à 200, p+q+r+s+t vaut de 3 à 500, chaque motif répété entre parenthèses peut être organisé de façon aléatoire, d est indépendamment un entier de 0 à 8, le motif avec d peut être linéaire ou ramifié, et possède au moins un groupe silyle hydrolysable à une ou plusieurs extrémités de la chaîne moléculaire.

6. Élément hydrofuge et oléofuge selon l'une quelconque des revendications 1 à 5, dans lequel le composé fluoré hydrolysable est au moins un composé choisi parmi des composés organosiliciés fluorés hydrolysables ayant les formules générales (1) à (5) :
(A-Rf)_{α}-ZW_{β} (1)
Rf-(ZW_{β})₂ (2)
Z'-(Rf-ZW_{β})_{γ} (3)
dans lesquelles Rf est un résidu de polymère perfluorooxyalkylène linéaire divalent de formule :
-(CF₂)_{d}-O-(CF₂O)ₚ(CF₂CF₂O)_{q}(CF₂CF₂CF₂₀)ᵣ(CF₂CF₂CF₂CF₂O)ₛ(CF(CF₃)CF₂O)ₜ-(CF₂)_{d}-,
dans laquelle p, q, r, s et t sont chacun, indépendamment les uns des autres, un entier de 0 à 200, p+q+r+s+t vaut de 3 à 500, chaque motif répété entre parenthèses peut être organisé de façon aléatoire, d est indépendamment un entier de 0 à 8, le motif avec d peut être linéaire ou ramifié, A est le fluor, l'hydrogène ou un groupe fluoré monovalent terminé par -CF₃, -CF₂H ou -CH₂F, Z et Z' sont chacun, indépendamment l'un de l'autre, une liaison simple, ou un groupe organique divalent à octavalent qui peut contenir de l'azote, de l'oxygène, du silicium, du phosphore ou du soufre et qui peut être fluoré, W est un groupe organique monovalent terminé par un groupe hydrolysable, α et β sont chacun, indépendamment l'un de l'autre, un entier de 1 à 7, α+β vaut de 2 à 8 et γ est un entier de 2 à 8,
A-Rf-Q-(Y)_{δ}-B (4)
Rf-(Q-(Y)_{δ}-B)₂ (5)
dans lesquelles Rf et A sont tel que défini ci-dessus, Q est une liaison simple ou un groupe organique divalent, chaque δ est indépendamment un entier de 1 à 10, Y est un groupe organique divalent possédant un groupe hydrolysable, et B est l'hydrogène, un alkyle en C₁ à C₄ ou un halogène.

7. Élément hydrofuge et oléofuge selon la revendication 6, dans lequel le composé organosilicié fluoré hydrolysable est choisi parmi les suivants : 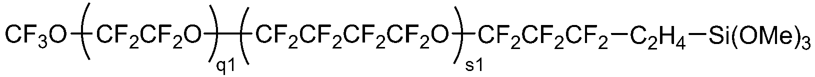 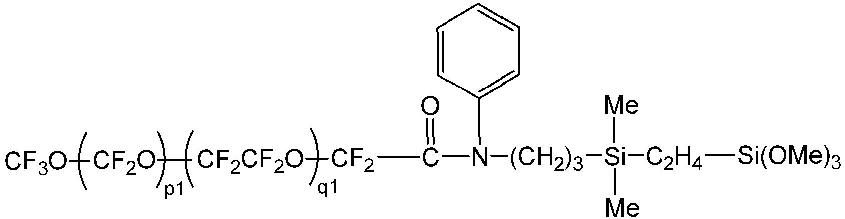 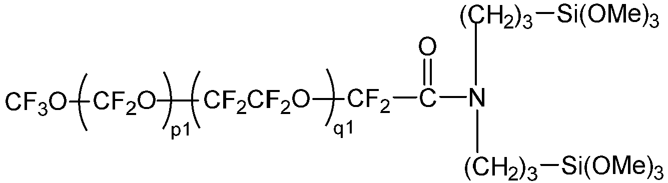 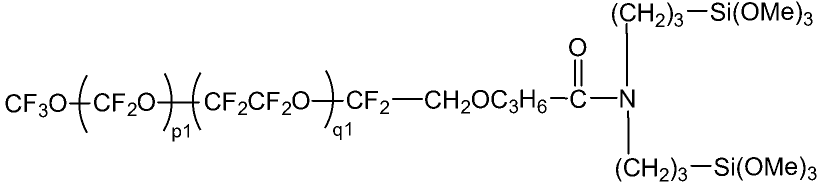 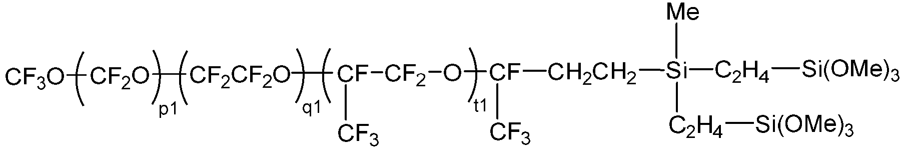 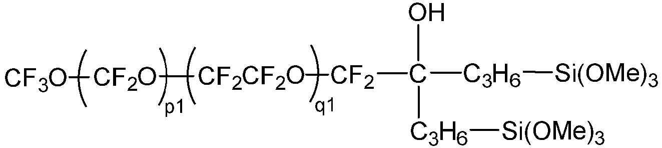 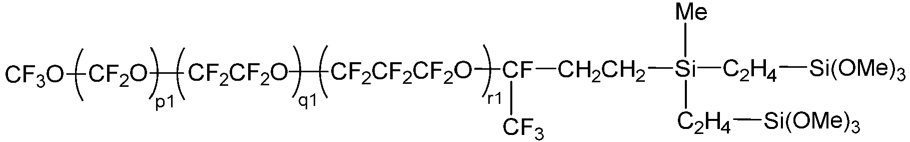 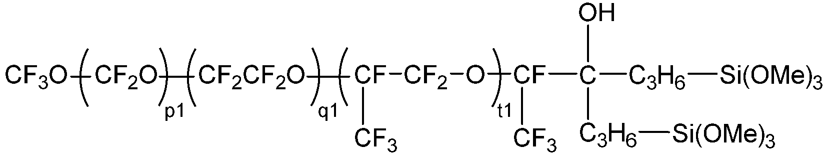 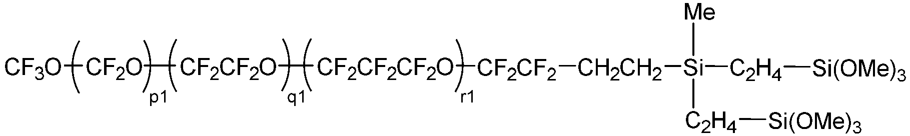 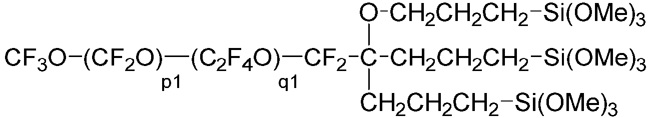 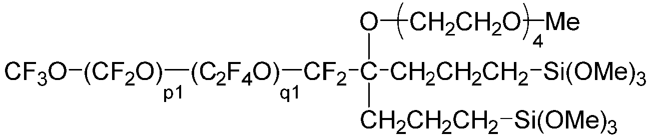 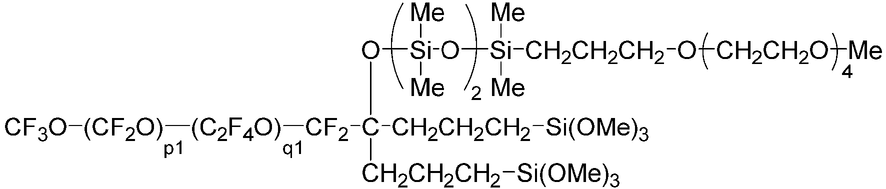 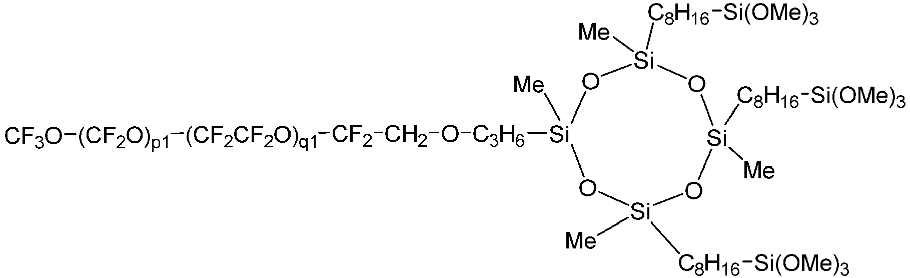 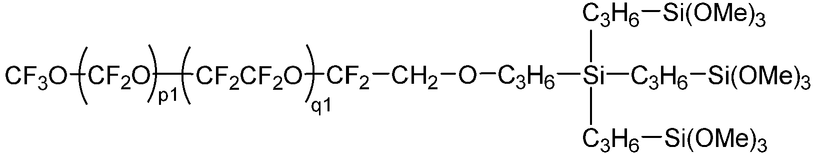 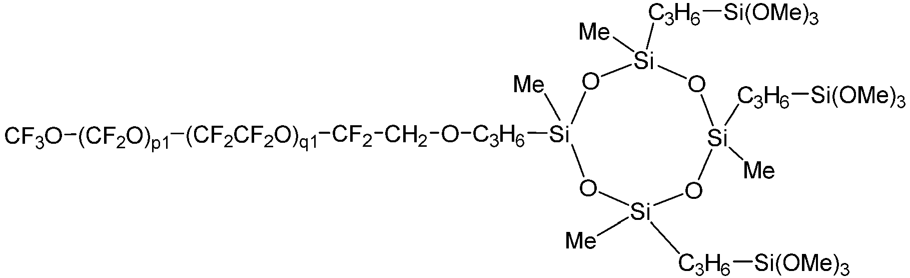 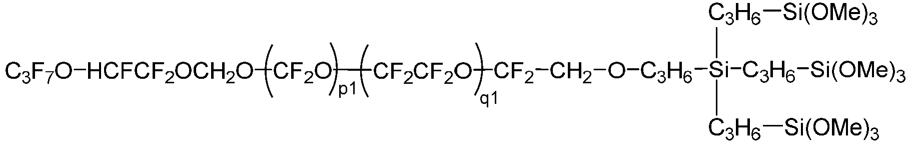 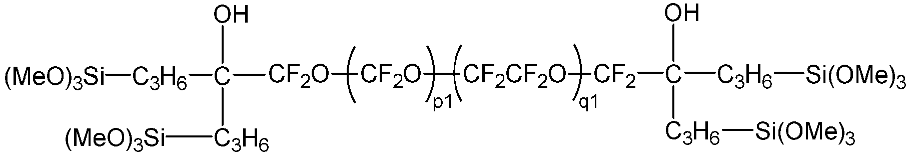 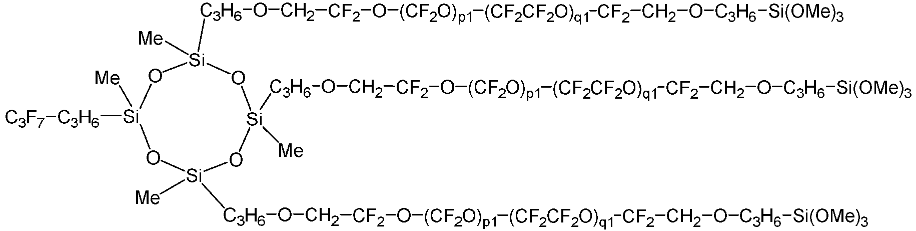 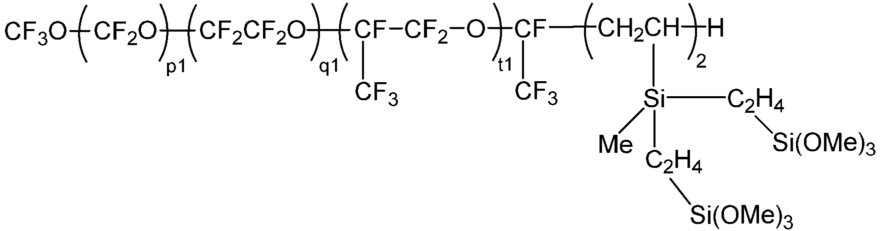 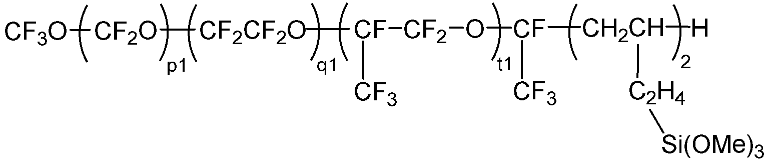 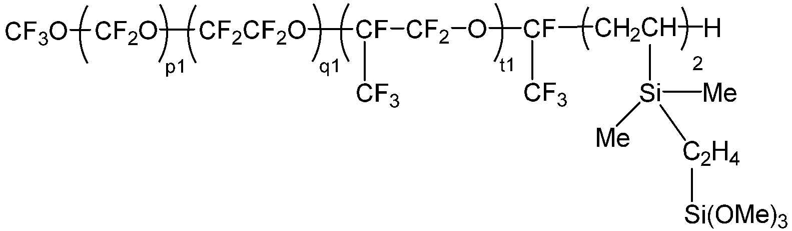 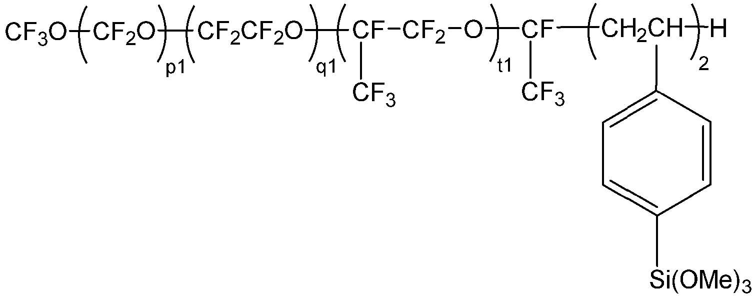 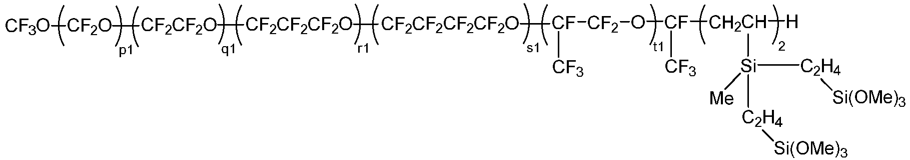 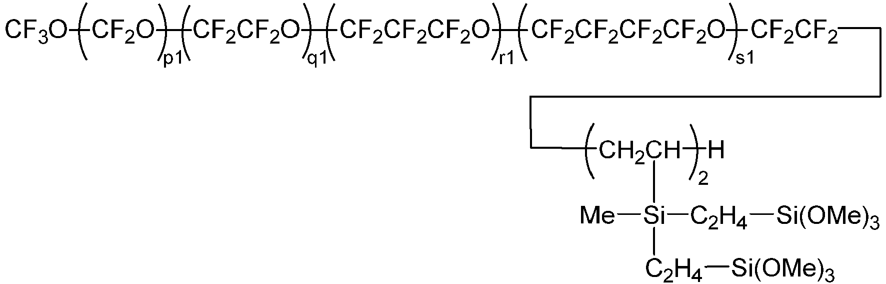 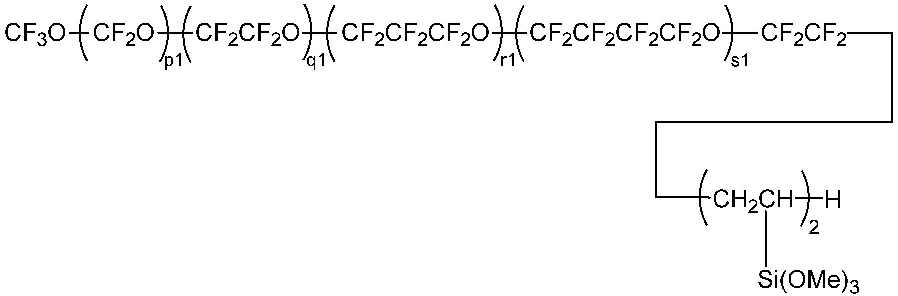 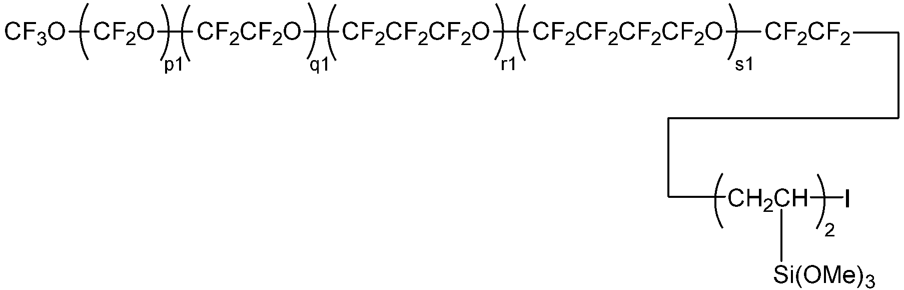 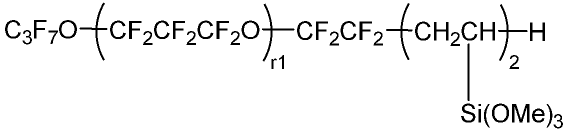 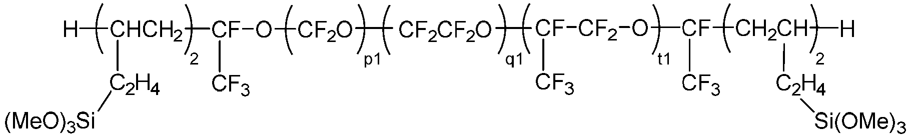 dans lesquels Me est un méthyle, p1, q1, r1, s1, et t1 sont chacun, indépendamment les uns des autres, un entier de 1 à 200, la somme de p1, q1, r1, s1 et t1 vaut de 3 à 500, chaque motif répété entre parenthèses peut être organisé de façon aléatoire.

8. Élément hydrofuge et oléofuge selon l'une quelconque des revendications 1 à 7, dans lequel le substrat est constitué d'une résine, d'une céramique, d'un métal, de quartz, d'un verre, de saphir, ou de diamant.

9. Procédé de préparation de l'élément hydrofuge et oléofuge selon l'une quelconque des revendications 1 à 8, le procédé comportant les étapes consistant à :
former une couche de film fonctionnel sur au moins une surface d'un substrat, la couche de film fonctionnel étant une couche de dioxyde de silicium ayant une épaisseur de 10 à 500 nm ou ayant une structure multicouche qui inclut au moins une couche la plus à l'extérieur composée de dioxyde de silicium et ayant une épaisseur de 10 à 500 nm,
appliquer à l'état humide une solution d'un composé d'organopolysiloxane possédant une pluralité de groupes silanol dans la molécule dans un solvant sur la surface extérieure de la couche de film fonctionnel, et laisser ensuite le solvant s'évaporer pour former et appliquer une couche d'apprêt ayant une épaisseur de 10 à 500 nm sur au moins une surface du substrat, le composé d'organopolysiloxane possédant une pluralité de groupes silanol dans la molécule étant un condensat partiel hydrolytique d'un tétraalcoxysilane et ayant une teneur en silanol de 0,002 à 0,042 mol/g, et
appliquer à l'état humide une solution d'un composé fluoré hydrolysable dans un solvant sur la surface extérieure de la couche d'apprêt, et laisser ensuite le solvant s'évaporer, ou laisser le solvant s'évaporer à partir de la solution et appliquer à l'état sec le composé fluoré hydrolysable sur la surface extérieure de la couche d'apprêt, et laisser durcir le composé fluoré hydrolysable pour former et appliquer une couche hydrofuge et oléofuge sur la surface extérieure de la couche d'apprêt.
